# EUROPEAN PATENT APPLICATION

(11) **EP 4 831 771 A1**
(43) Date of publication of application: **28.10.2026**
(21) Application number: 26168578.8
(22) Date of filing: 27.03.2026
(51) Int. Cl.: G06F 1/16

(54) **DISPLAY APPARATUS AND ELECTRONIC DEVICE INCLUDING THE DISPLAY APPARATUS**

(30) Priority: 25.04.2025 KR 20250054640
(71) Applicant: Samsung Display Co., Ltd., Yongin-si, Gyeonggi-do 17113 (KR)
(72) Inventor: Jo, Hyunseong, 17113 Yongin-si, Gyeonggi-do (KR); Kim, Donghyeon, 17113 Yongin-si, Gyeonggi-do (KR); Park, Changmin, 17113 Yongin-si, Gyeonggi-do (KR); Ha, Bora, 17113 Yongin-si, Gyeonggi-do (KR)
(74) Representative: Gulde & Partner

(57) **Abstract**

The display apparatus includes a substrate, a reinforcing member on a surface of the substrate, and a support plate on the reinforcing member. The support plate includes a first region having a plurality of first opening patterns corresponding to a first portion of the substrate, a second region connected to the first region and having a plurality of second opening patterns corresponding to a second portion of the substrate, and a third region connected to the second region and having a plurality of third opening patterns corresponding to a third portion of the substrate. A lengthwise direction of one of the plurality of first opening patterns and a lengthwise direction of one of the plurality of second opening patterns are identical to each other in a first direction, and a lengthwise direction of one of the plurality of third opening patterns is different from the first direction.

## Description

### BACKGROUND

### 1. Field

One or more embodiments relate to devices, and more particularly, to a display apparatus and an electronic device.

### 2. Description of the Related Art

Electronic devices for mobile use have come into widespread use. Recently, tablet personal computers (PCs), in addition to small-sized electronic devices such as mobile phones, have been widely used as mobile electronic devices.

In order to support various functions, mobile electronic devices include a display panel for providing a user with visual information such as images or video. Recently, as components for driving such display panels have decreased in size, occupancy of the display panels in electronic devices is gradually increasing. Moreover, a structure that may be curved to have a predetermined angle from a flat state has been developed.

### SUMMARY

Typically, when a display panel is subjected to bending, rolling or sliding movements, a portion of the display panel may have a varied shape. In this case, various structures may be applied to the display panel to facilitate shape variation while supporting the display panel. In particular, an opening pattern may be arranged on the display panel to smoothly change the shape of the display panel. In this case, according to a location of the opening pattern, a shape of the opening pattern, or the like, the opening pattern may be visible to the outside or a surface where an image is realized may be curved. One or more embodiments include a display panel that reduces visibility of an opening pattern to the outside, and an electronic device including the display panel.

Additional aspects will be set forth in part in the description which follows and, in part, will be apparent from the description, or may be learned by practice of the presented embodiments of the disclosure.

According to one or more embodiments, a display apparatus and an electronic device is provided according to the independent claims. A display apparatus may include a substrate including a display layer disposed on a first surface of the substrate and having at least a portion that is selectively bent, a reinforcing member disposed on a second surface of the substrate, the second surface being opposite to the first surface, and a support plate disposed on the reinforcing member. The support plate may include a first region having a plurality of first opening patterns arranged to correspond to a first portion of the substrate, a second region connected to the first region and having a plurality of second opening patterns arranged to correspond to a second portion of the substrate, and a third region connected to the second region and having a plurality of third opening patterns arranged to correspond to a third portion of the substrate. Each of the plurality of first opening patterns, each of the plurality of second opening patterns, and each of the plurality of third opening patterns may include widths and lengths, the lengths being greater than the widths, a lengthwise direction of at least one of the plurality of first opening patterns and a lengthwise direction of at least one of the plurality of second opening patterns are identical to each other in a first direction, and a lengthwise direction of at least one of the plurality of third opening patterns is different from the first direction.

Lengths of some of the plurality of second opening patterns may sequentially decrease in a second direction away from the first region.

A length of each of the plurality of second opening patterns arranged in the second region may sequentially decrease by a certain value in the second direction.

An interval between adjacent second opening patterns among the plurality of second opening patterns may increase in a second direction away from the first region.

The interval between the adjacent second opening patterns in the second direction may range from 5 µm to 1 mm.

The interval between the adjacent second opening patterns in the second direction may sequentially increase by a certain value in a direction away from the first region.

Some of the plurality of second opening patterns have centers which are arranged on any straight line parallel to a width direction of the second opening pattern and have respective ends arranged on a diagonal line or a curve.

First opening patterns adjacent to each other among the plurality of first opening patterns in the first direction overlap each other at least partially in a second direction different from the first direction and/or second opening patterns adjacent to each other among the plurality of second opening patterns in the first direction may overlap each other at least partially in the second direction different from the first direction.

An angle formed between the lengthwise direction of each of the plurality of third opening patterns and the first direction may increase in a direction away from the second region.

The lengthwise direction of the third opening pattern disposed at an outermost edge of the third region among the plurality of third opening patterns may be perpendicular to the first direction.

An interval between first opening patterns arranged in a second direction different from the first direction from among the plurality of first opening patterns may be constant.

The lengths of the third opening patterns may respectively be less than the lengths of the first opening patterns.

The second region may be 5% to 40% of a total area obtained by summing respective areas of the first region, the second region, and the third region.

The third region may be more than 0% to 10% of a total area obtained by summing respective areas of the first region, the second region, and the third region.

According to one or more embodiments, a display apparatus may include a substrate, a reinforcing member disposed on a lower surface of the substrate, and a support plate disposed on a lower surface of the reinforcing member. The support plate may include a variable region having a varied shape and in which a plurality of opening patterns are arranged. Each of the plurality of opening patterns may have a length and a width smaller than the length, some of the plurality of opening patterns may have centers arranged on a first straight line in a second direction different from a first direction, and a lengthwise direction of each of the plurality of opening patterns may be parallel to the first direction, the some of the plurality of opening patterns having centers arranged on the first straight line may include a first group of opening patterns in which an interval between adjacent opening patterns among the first group of opening patterns is constant, and a second group of opening patterns in which an interval between adjacent opening patterns among the second group of opening patterns varies in the first direction, and a first subgroup of opening patterns comprised among the second group of opening patterns is arranged in a 2-1 pattern region in which lengths of the first subgroup of opening patterns are constant, and a second subgroup of opening patterns comprised among the second group of opening patterns is arranged in a 2-2 pattern region in which lengths of the second subgroup of opening patterns sequentially decrease.

Ends of the second subgroup of opening patterns arranged in the 2-2 pattern region may be arranged on an inclined line or curved line inclined with respect to the first direction.

According to one or more embodiments, a display apparatus may include a substrate, a reinforcing member disposed on a lower surface of the substrate, a support plate disposed on a lower surface of the reinforcing member, and an adhesive member disposed between the reinforcing member and the support plate. The support plate may include a variable region having a varied shape and in which a plurality of opening patterns are arranged. Some of the plurality of opening patterns may include a first group of opening patterns in which an interval between adjacent opening patterns among the first group of opening patterns is constant, and a second group of opening patterns in which an interval between adjacent opening patterns among the second group of opening patterns varies in the first direction. The interval between the adjacent aperture patterns among the second group of opening patterns may increase in a direction away from the first group of opening patterns. The adhesive member may include an opening corresponding to the variable region.

According to one or more embodiments, an electronic device may include a housing, a display apparatus that is accommodated in the housing and is foldable or is capable of being withdrawn from a portion of the housing, and an input module disposed in the housing and which receives a user signal. The electronic device may comprise one or more of the aforementioned embodiments of a display apparatus.

The first region, the second region, and the third region may be arranged sequentially from one end of the housing to another end of the housing.

The first region may be disposed inside a portion of the housing in which the input module is disposed, and at least a portion of the first region may move inside the housing when the display apparatus slides.

Through these embodiments, a visibility of an opening pattern to the outside is reduced. In particular, through these embodiments, a curvature of a bent portion is not visible to a user. These and/or other aspects will become apparent and more readily appreciated from the following description of the embodiments, taken in conjunction with the accompanying drawings.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram schematically illustrating a control flow of an electronic device according to an embodiment;
FIGS. 2 through 4 are perspective views of electronic devices according to embodiments;
FIGS. 5A and 5B are schematic perspective views of an electronic device according to an embodiment;
FIG. 6A is a schematic cross-sectional view of a portion of the electronic device of FIG. 5A;
FIG. 6B is a schematic cross-sectional view of a reinforcing member illustrated in FIG. 6A;
FIG. 7 is a schematic plan view of a support plate illustrated in FIG. 6A;
FIGS. 8A through 8C are schematic plan views of an area AR illustrated in FIG. 7;
FIG. 9 is a schematic cross-sectional view of a portion of the electronic device of FIG. 5A;
FIGS. 10A through 10C are schematic plan views of a portion of a variable region illustrated in FIG. 9;
FIG. 11 is a schematic perspective view of an electronic device according to another embodiment;
FIGS. 12A and 12B are schematic cross-sectional views of a portion of the electronic device of FIG. 11;
FIG. 12C is a schematic plan view of a support plate of FIG. 12A or 12B;
FIG. 13 is a schematic perspective view of an electronic device according to another embodiment;
FIG. 14A is a schematic cross-sectional view of a portion of the electronic device of FIG. 13;
FIG. 14B is a schematic plan view of a support plate shown in FIG. 14A;
FIG. 15A is a schematic plan view of a display panel and a display circuit board of the electronic device illustrated in FIG. 2, FIG. 3, FIG. 4, FIG. 5A, FIG. 11, or FIG. 13;
FIG. 15B is a schematic side view of the display panel and the display circuit board illustrated in FIG. 15A;
FIG. 16 is a schematic plan view of the display panel and the display circuit board illustrated in FIG. 15A;
FIG. 17 is an equivalent circuit diagram of one subpixel arranged in a display area of the display panel of FIG. 16; and
FIG. 18 is a schematic cross-sectional view of a portion of the display area of the display panel of FIG. 16.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are described herein, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the disclosure allows for various changes and numerous embodiments, particular embodiments will be illustrated in the drawings and described in detail in the written description. Hereinafter, effects and features of the disclosure and a method for accomplishing them will be described more fully with reference to the accompanying drawings, in which embodiments of the disclosure are illustrated. The disclosure may, however, be embodied in many different forms and should not be construed as limited to the embodiments set forth herein.

One or more embodiments will be described herein in more detail with reference to the accompanying drawings. Those components that are the same as or are in correspondence with each other are rendered the same reference numeral regardless of the figure number, and redundant explanations are omitted.

It will be understood that although the terms "first," "second," and the like may be used herein to describe various components, these components should not be limited by these terms. These components are used to distinguish one component from another.

As used herein, the singular forms "a," "an," and "the" are intended to include the plural forms as well, unless the context clearly indicates otherwise.

It will be further understood that the terms "includes," "including," "comprises," and/or "comprising" used herein specify the presence of stated features or components, but do not preclude the presence or addition of one or more other features or components.

It will be understood that when a layer, region, or component is referred to as being "formed on" another layer, region, or component, it can be directly or indirectly formed on the other layer, region, or component. That is, for example, intervening layers, regions, or components may be present.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

The terms "about" or "approximately" as used herein are inclusive of the stated value and include a suitable range of deviation for the particular value as determined by one of ordinary skill in the art, considering the measurement in question and the error associated with measurement of the particular quantity. The terms "about" or "approximately" can mean within one or more standard deviations, or within ± 30%, 20%, 10%, or 5% of the stated value, for example.

Sizes of elements in the drawings may be exaggerated or reduced for convenience of explanation. For example, since sizes and thicknesses of components in the drawings are arbitrarily illustrated for convenience of explanation, embodiments are not limited thereto.

In the following examples, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

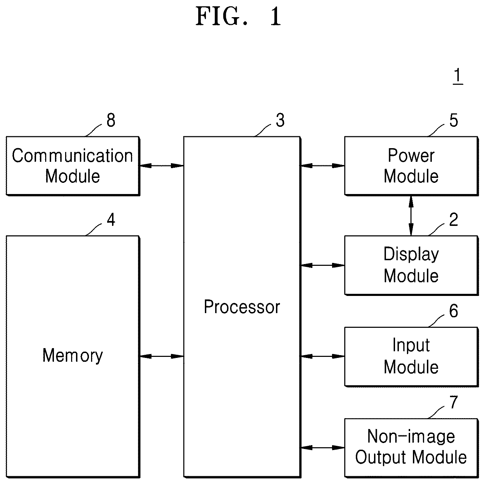

FIG. 1 is a block diagram schematically illustrating a control flow of an electronic device 1 according to an embodiment.

Referring to FIG. 1, the electronic device 1 according to an embodiment may include a display module 2 including a display apparatus, a processor 3, a memory 4, and a power module 5.

The processor 3 may include at least one of a central processing unit (CPU), an application processor (AP), a graphics processing unit (GPU), a communication processor (CP), an image signal processor (ISP), and a controller. According to an embodiment, the processor 3 may be provided as two or more processors divided by functional or structural aspects. For example, the processor 3 may include a main processor in the form of a first drive chip including a CPU, and an auxiliary processor in the form of a second drive chip including a controller that receives an image signal from the main processor and processes the image signal to conform to the interface specifications of the display module 2.

The memory 4 may include at least one of a non-volatile memory and a volatile memory. The memory 4 may store data information for an operation of the processor 3 or the display module 2. When the processor 3 executes an application stored in the memory 4, an image data signal and/or an input control signal may be transmitted to the display module 2, and the display module 2 may process the received signal and output image information through a display screen.

The power module 5 may include a power supply module, such as a power adapter or a battery device, and a power conversion module that converts power supplied by the power supply module to generate power for an operation of the electronic device 1. Power conversion by the power conversion module may include, but is not necessarily limited to, DC-to-DC conversion, AC-to-DC conversion, and DC-to-AC conversion.

The electronic device 1 may further include an input module 6, a non-image output module 7, and/or a communication module 8.

The input module 6 may provide input information to the processor 3 and/or the display module 2. The input module 6 may include various sensor modules as well as physical buttons, a keyboard, and a microphone. Examples of the sensor modules may include a touch sensor, a pressure sensor, a distance sensor, a position sensor, a digitizer, a motion recognition sensor, a camera sensor, a light-receiving sensor, a photoelectric conversion sensor, and a temperature sensor, as well as biosensors, such as a blood pressure sensor, a blood sugar sensor, an electrocardiogram sensor, and a heart rate sensor.

The non-image output module 7 may receive information other than an image received from the processor 3, and may provide the information to a user. Examples of the non-image output module 7 may include a sound module, a haptic module, and/or a light-emitting module, and may include other functional modules unique to a specific electronic device (e.g., a cooling module of a refrigerator).

The communication module 8, which is a module responsible for transmitting and receiving information between the electronic device 1 and an external device, may include a reception unit and a transmission unit. The communication module 8 may include various wireless communication modules, such as a mobile communication module, a Wi-Fi module, and a Bluetooth module, or various wired communication modules.

At least one of the components of the electronic device 1 described herein may be included in display apparatuses according to embodiments described herein. In some aspects, some of the individual modules functionally included within a module may be included within a display apparatus, and the others may be provided separately from the display apparatus. For example, the display module 2 may include the display apparatus, and the processor 3, the memory 4, and the power module 5 may be provided in the form of other devices within the electronic device 1 rather than the display apparatus. As another example, the power module 5 may be provided within the display apparatus, and may supply power to the processor 3 and the memory 4 provided within the electronic device 1 other than the display apparatus. However, embodiments are not necessarily limited to the above examples.

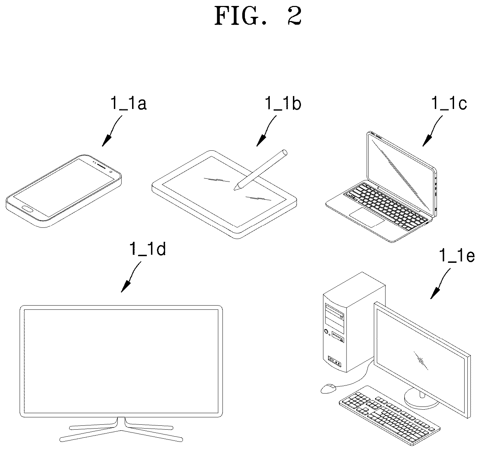

FIGS. 2 through 4 are perspective views of electronic devices according to embodiments.

FIG. 2 illustrates, as examples of electronic devices, a smartphone 1_1a, a tablet personal computer (PC) 1_1b, a laptop 1_1c, a TV 1_1d, and a computer monitor 1_1e.

The smartphone 1_1a may include an input module, such as a touch sensor, and a communication module, in addition to the display module 2. The smartphone 1_1a may process information received through the communication module or other input modules, and may display the information through a display apparatus of a display module.

The tablet PC 1_1b, the laptop 1_1c, the TV 1_1d, and the computer monitor 1_1e may include a display module and an input module, similar to the smartphone 1_1a. In some cases, the tablet PC 1_1b, the laptop 1_1c, the TV 1_1d, and the computer monitor 1_1e may further include communication modules.

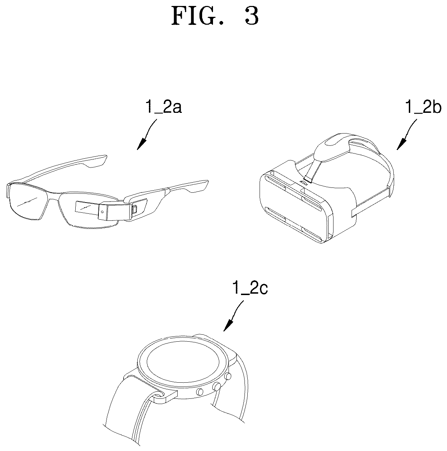

FIG. 3 illustrates a case where an electronic device including a display module is applied to a wearable electronic device. The wearable electronic device may be smart glasses 1_2a, a head mounted display 1_2b, a smart watch 1_2c, or the like.

The smart glasses 1_2a and the head mounted display 1_2b may include a display module for emitting a display image and a reflector for reflecting the emitted display image to provide a result of the reflection to the user's eyes, thereby providing a virtual reality or augmented reality screen image to the user.

The smart watch 1_2c may include a biosensor as an input device, and may provide biometric information recognized by the biosensor to the user through a display module.

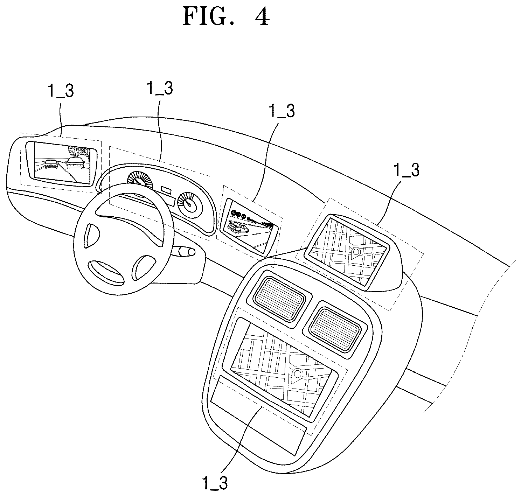

FIG. 4 illustrates a case where an electronic device including a display module is applied to a vehicle. For example, an electronic device 1_3 may be applied to dashboards, center fasciae, and the like of automobiles, or may be applied to, for example, center information displays (CIDs) arranged on the dashboards of automobiles or room mirror displays that replace the side mirrors of automobiles.

Although not illustrated, electronic devices to which display apparatuses according to embodiments are applied may include not only devices that mainly perform screen display, such as a billboard, an electronic board, and a game console, but also various home appliances that display information through display modules, such as a refrigerator, a washing machine, a dryer, an air conditioner, and a robot vacuum cleaner. In some aspects, when a display module has a function of transmitting light, the display module may be applied to electronic devices, such as smart windows or transparent display apparatuses that display both a background and a displayed image. The types of electronic devices according to embodiments are not limited to the example embodiments described herein, and application of various other electronic devices is also possible.

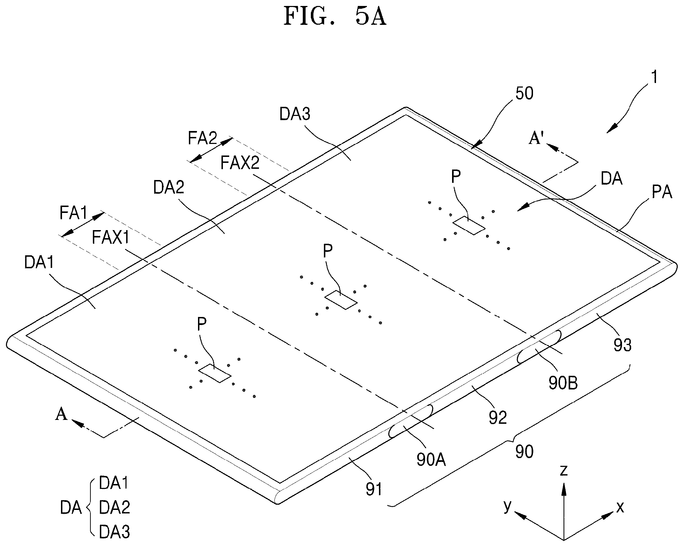

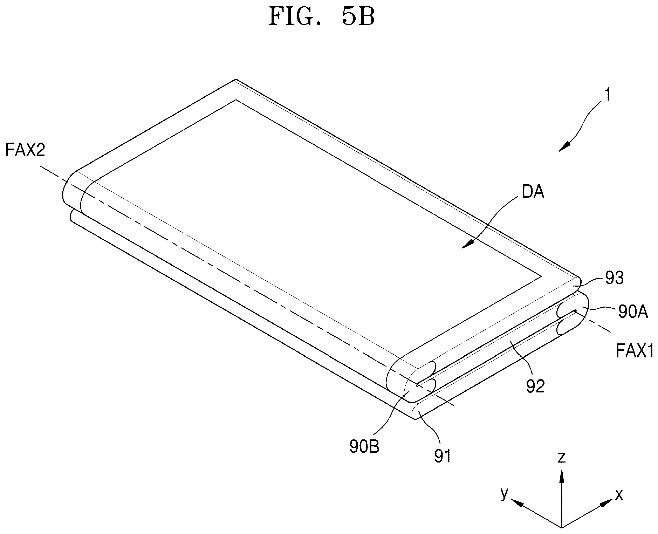

FIGS. 5A and 5B are schematic perspective views of an electronic device according to an embodiment. FIG. 5A is a perspective view of the electronic device 1 in an unfolded state, and FIG. 5B is a perspective view of the electronic device 1 in a folded state.

Referring to FIGS. 5A and 5B, the electronic device 1 is a device that displays a moving picture or a still image, and thus examples thereof may include various products such as not only portable electronic devices, such as mobile phones, smartphones, tablet personal computers (PCs), mobile communication terminals, electronic notebooks, electronic books, portable multimedia players (PMPs), navigation devices, and ultra mobile PCs (UMPCs) but also televisions, notebooks, monitors, advertisement boards, and Internet of things (IoT) devices. Examples of the electronic device 1 may also include wearable devices such as a smart watch, a watch phone, a glasses-type display, and a head mounted display (HMD). Examples of the electronic device 1 may also include dashboards of automobiles, center information displays (CIDs) of the center fasciae or dashboards of automobiles, room mirror displays that replace the side mirrors of automobiles, and displays arranged on the rear sides of front seats to serve as entertainment devices for back seat passengers of automobiles.

The electronic device 1 may include a display apparatus including a display panel 50, and a lower cover 90, which is a housing. The display panel 50 may include a display area DA where an image is displayed, and a peripheral area PA surrounding the display area DA. In the display area DA, subpixels P including display elements may be arranged. In this case, a plurality of subpixels P may be included, and may be spaced apart from one another. Some of the plurality of subpixels P, some of the plurality of subpixels P, and some of the plurality of subpixels P may emit light beams of different colors. The electronic device 1 may provide an image by using light emitted by the subpixels P arranged in the display area DA. The peripheral area PA may be a non-display area where no subpixels P are arranged.

The display area DA may include a first display area DA1, a second display area DA2, and a third display area DA3. Subpixels P may be arranged in each of the first display area DA1, the second display area DA2, and the third display area DA3. The electronic device 1 may provide an image through the subpixels P arranged in the first display area DA1, the second display area DA2, and the third display area DA3. The first display area DA1, the second display area DA2, and the third display area DA3 may be surrounded by the peripheral area PA.

The display panel 50 displays (or outputs) information that is processed by the electronic device 1. For example, the display panel 50 may display execution screen information of an application being driven by the electronic device 1, or may display user interface (UI) and graphical user interface (GUI) information based on the execution screen information. The display panel 50 may include a display layer that displays an image, and a touch screen layer that senses a touch input of a user. Accordingly, the display panel 50 may function as one of input devices providing input interfaces between the electronic device 1 and a user, and also function as one of output units providing output interfaces between the electronic device 1 and the user.

Although an organic light-emitting display panel will now be illustrated and described as the display panel 50, the display panel 50 according to the disclosure is not limited thereto. According to an embodiment, the display panel 50 according to the disclosure may be an inorganic light-emitting display, a quantum dot light-emitting display, or the like. For example, an emission layer of a display element included in the display panel 50 may include an organic material, include an inorganic material, include quantum dots, include an organic material and quantum dots, or include an inorganic material and quantum dots.

According to an embodiment, the display panel 50 may be a flexible display panel that is flexible and thus may be easily bent, folded, or rolled. For example, the display panel 50 may be a foldable display panel, a curved display panel having a curved display surface, a bent display panel of which an area other than a display surface is bent, a rollable display panel, or a stretchable display panel. According to an embodiment, the display panel 50 may be a rigid display panel that is rigid and thus may not be easily bent.

According to an embodiment, the display panel 50 may include a first folding axis FAX1 and a second folding axis FAX2. The display panel 50 may be folded about the first folding axis FAX1 and the second folding axis FAX2.

The first display area DA1 and the second display area DA2 may be defined with the first folding axis FAX1 running between the first display area DA1 and the second display area DA2. The second display area DA2 and the third display area DA3 may be defined with the second folding axis FAX2 running between the second display area DA2 and the third display area DA3.

The lower cover 90 may form a lower exterior of the electronic device 1. The lower cover 90 may include plastic, metal, or both plastic and metal. The lower cover 90 may include a first lower cover portion 91, a second lower cover portion 92, and a third lower cover portion 93 that support the display panel 50. The lower cover 90 may be folded about the first folding axis FAX1 between the first lower cover portion 91 and the second lower cover portion 92. The lower cover 90 may also be folded about the second folding axis FAX2 between the second lower cover portion 92 and the third lower cover portion 93.

According to an embodiment, a first hinge portion 90A may be provided between the first lower cover portion 91 and the second lower cover portion 92, and a second hinge portion 90B may be provided between the second lower cover portion 92 and the third lower cover portion 93.

According to an embodiment, the first display area DA1 and the second display area DA2 may be folded about the first folding axis FAX1 to face each other. In other words, the first lower cover portion 91 and the second lower cover portion 92 may be folded about the first folding axis FAX1 to face each other. According to an embodiment, the first display area DA1 and the second display area DA2 may be folded about the first folding axis FAX1 not to face each other.

According to an embodiment, the second display area DA2 and the third display area DA3 may be folded about the second folding axis FAX2 not to face each other. In other words, the second lower cover portion 92 and the third lower cover portion 93 may be folded about the second folding axis FAX2 not to face each other. According to an embodiment, the second display area DA2 and the third display area DA3 may be folded about the second folding axis FAX2 to face each other.

According to an embodiment, in the case of in-folding where the first display area DA1 and the second display area DA2 are in-folded to face each other, a radius of curvature of a folded portion may be 5R (e.g., R=1 mm) or less. Alternatively, in the case of in-folding where the first display area DA1 and the second display area DA2 are in-folded to face each other, the radius of curvature of the folded portion may be 3R or less or may be 1R or less.

According to an embodiment, in the case of out-folding where the second display area DA2 and the third display area DA3 are out-folded not to face each other, a curvature of a folded portion may be 5R or less. Alternatively, in the case of out-folding where the second display area DA2 and the third display area DA3 are out-folded not to face each other, the curvature of the folded portion may be 4R or less.

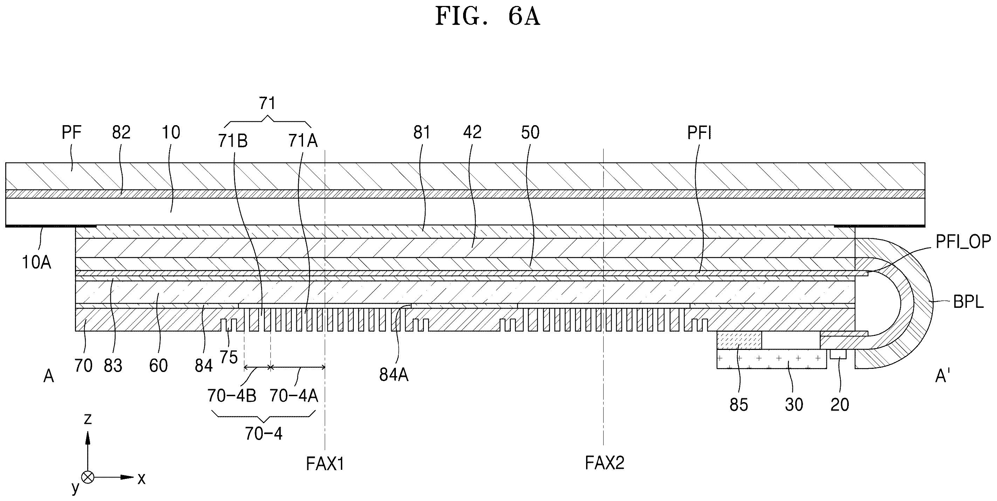

The electronic device 1 may include a main circuit board. The main circuit board may be provided separately from or integrally with a display circuit board 30 of FIG. 6A. At this time, when the main circuit board and the display circuit board 30 are provided separately so as to be distinguished from each other, the main circuit board and the display circuit board 30 may be connected to each other using a cable or the like. However, for convenience of description, a case where the main circuit board and the display circuit board 30 are provided separately will now be focused on and described in detail.

The main circuit board may include a main processor (not illustrated), a camera device (not illustrated), a main connector (not illustrated), and components (not illustrated). The main processor may be implemented as an integrated circuit (IC). The camera device may be arranged on both upper and lower surfaces of the main circuit board, and each of the main processor and the main connector may be arranged on one of the upper and lower surfaces of the main circuit board.

The main processor may control all functions of the electronic device 1. For example, the main processor may output digital video data to a data driver 20 of FIG. 6A via the display circuit board 30 such that the display panel 50 displays an image. The main processor may receive sensing data from a touch sensor driver. The main processor may determine whether there is a user's touch, according to the sensing data, and may execute an operation corresponding to a direct touch or proximity touch of the user. For example, the main processor may calculate the touch coordinate of the user by analyzing the sensing data, and then may execute an application or operation indicated by an icon touched by the user. The main processor may be an application processor, a central processing unit, or a system chip each realized as an IC.

The camera may process an image frame such as a still image or video obtained by an image sensor in a camera mode, and output a result of the processing to the main processor. The camera device may include at least one of a camera sensor (for example, a charge-coupled device (CCD) or a complementary metal-oxide-semiconductor (CMOS)), a photo sensor (or an image sensor), and a laser sensor. The camera device may be connected to the image sensor from among the components overlapped by a component area, and may process an image input to the image sensor.

A cable that has passed through a cable hole of a bracket may be connected to a main connector, and thus the main circuit board may be electrically connected to the display circuit board.

The main circuit board may further include, in addition to the main processor, the camera device, and the main connector, at least one of the components included in a wireless communication unit, at least one of the components included in an input unit, at least one of the components included in a sensor unit, at least one of the components included in an output unit, at least one of the components included in an interface unit, a memory, and a power supplier.

The wireless communication unit may include at least one of a broadcast reception module, a mobile communication module, a wireless Internet module, a short-distance communication module, and a position information module.

The broadcast reception module may receive a broadcasting signal and/or broadcasting-related information from an external broadcasting management server via a broadcasting channel. The broadcasting channel may be a satellite channel, a ground wave channel, or the like.

The mobile communication module may transmit or receive a wireless signal to or from at least one of a base station, an external terminal, and a server on a mobile communication network established according to technology standards or communication methods for mobile communication (for example, Global System for Mobile communication (GSM), Code Division Multi Access (CDMA), Code Division Multi Access 2000 (CDMA2000), Enhanced Voice-Data Optimized or Enhanced Voice-Data Only (EV-DO), Wideband CDMA (WCDMA), High Speed Downlink Packet Access (HSDPA), High Speed Uplink Packet Access (HSUPA), Long Term Evolution (LTE), and Long Term Evolution-Advanced (LTE-A)). Examples of the wireless signal may include a voice call signal, a video call signal, and various types of data according to text and/or multimedia messages transmission.

The wireless Internet module may indicate a module for wireless Internet access. The wireless Internet module may be configured to transmit or receive a wireless signal in a communication network based on the wireless Internet technologies. The wireless Internet technologies may be, for example, a Wireless LAN (WLAN), Wireless-Fidelity (Wi-Fi), Wi-Fi Direct, and Digital Living Network Alliance (DLNA).

The short-distance communication module is for short-range communication, and thus may support short-distance communication by using at least one technology from among Bluetooth^{™}, Radio Frequency Identification (RFID), Infrared Data Association (IrDA), Ultra Wideband (UWB), ZigBee, Near Field Communication (NFC), Wi-Fi, Wi-Fi Direct, and Wireless Universal Serial Bus (Wireless USB). The short-distance communication module may support wireless communication between the electronic device 1 and a wireless communication system, between the electronic device 1 and another electronic device, or between the electronic device 1 and a network where another electronic device (or an external server) is located, through wireless area networks. The wireless area networks may be wireless personal area networks. The other electronic device may be a wearable device capable of exchanging data with (or interoperating with) the electronic device 1.

The position information module is included to obtain a position (or a current position) of the electronic device 1, and thus representative examples of the position information module include a global positioning system (GPS) module and a WiFi module. For example, the electronic device 1 may obtain the position of the electronic device 1 by using a signal sent by a GPS satellite, when using a GPS module. When using a Wi-Fi module, the electronic device 1 may obtain the position of the electronic device 1, based on information of a wireless access point (AP) that transmits or receives a wireless signal to or from the Wi-Fi module. Because the position information module is used to obtain the position (or the current position) of the electronic device 1, the position information module is not limited to a module that directly calculates or obtains the position of the electronic device 1.

The input unit may include an image input unit such as the camera device for inputting an image signal, an audio input unit such as a microphone for inputting an audio signal, and an input device for receiving information from a user.

The camera device processes an image frame such as a still image or video obtained by the image sensor in a video call mode or an image capture mode. A processed image frame corresponding to a result of the processing may be displayed on the display panel 50 or may be stored in the memory.

The microphone processes an external audio signal into electrical audio data. The electrical audio data may be used in various ways according to a function currently being performed (or an application currently being executed) in the electronic device 1. Various noise removal algorithms for removing noise that is generated while receiving the external audio signal may be implemented in the microphone.

The main processor may control an operation of the electronic device 1 to correspond to information that is input via the input device. The input device may include mechanical input unit such as a button, a dome switch, a jog wheel, and a jog switch each located on a rear or lateral surface of the electronic device 1, or a touch input unit. The touch input unit may be implemented as a touch screen layer of the display panel 50.

The sensor unit may include at least one sensor that senses at least one of information within the electronic device 1, information of a surrounding environment of the electronic device 1, and user information and generates a sensing signal corresponding to one or more of the information. Based on such a sensing signal, the main processor may control driving or operation of the electronic device 1 or may perform data processing, a function, or an operation associated with an application provided in the electronic device 1. The sensor unit may include at least one of a proximity sensor, an illumination sensor, an acceleration sensor, a magnetic sensor, a gravity (G)-sensor, a gyroscope sensor, a motion sensor, an RGB sensor, an infrared (IR) sensor, a finger scan sensor, an ultrasonic sensor, an optical sensor, a battery gauge, an environment sensor (e.g., a barometer, a hygrometer, a thermometer, a radiation sensor, a heat sensor, and a gas sensor), and a chemical sensor (e.g., an electronic nose, a healthcare sensor, and a biometric sensor).

The proximity sensor is a sensor that senses the existence of an object that approaches a predetermined sensing surface or exists near the predetermined sensing surface, without mechanical contact, by using an electromagnetic force or IR rays. Examples of the proximity sensor include a transmission-type photoelectric sensor, a direct reflection-type photoelectric sensor, a mirror reflection-type photoelectric sensor, a high frequency oscillation-type proximity sensor, a capacity-type proximity sensor, a magnetic proximity sensor, and an infrared-type proximity sensor. The proximity sensor may not only sense a proximity touch operation but also may sense a proximity touch pattern such as a proximity touch distance, a proximity touch direction, a proximity touch speed, a proximity touch time, a proximity touch location, or a proximity touch moving state. The main processor may process data (or information) corresponding to the proximity touch operation and the proximity touch pattern both sensed by the proximity sensor, and may control visual information corresponding to the processed data to be displayed on the display panel 50.

The ultrasonic sensor may recognize location information of an object by using ultrasonic waves. The main processor may calculate the location of an object from information sensed by an optical sensor and a plurality of ultrasonic sensors. Because the speed of light is different from the speed of ultrasonic waves, the location of the object may be calculated using a time when light reaches the optical sensor and a time when ultrasonic waves reach the ultrasonic sensors.

The output unit generates an output associated with sight, hearing, or tactile sense, and thus may include at least one of the display panel 50, an audio output unit, a haptic module, and an optical output unit.

The audio output unit may output audio data received from the wireless communication unit in a call signal reception mode, a call or recording mode, a voice recognition mode, a broadcast reception mode, and the like, or audio data stored in the memory. The audio output unit also outputs an audio signal related with a function performed by the electronic device 1 (for example, a call signal receiving sound or a message receiving sound). The audio output unit may include a receiver and a speaker. A least one of the receiver and the speaker may be an audio generation device that is attached to a lower portion of the display panel 50 and vibrates the display panel 50 to output an audio. The audio generation device may be a piezoelectric element or piezoelectric actuator that shrinks and expands according to an electrical signal, or may be an exciter that generates a magnetic force by using a voice coil and vibrates the display panel 50.

The haptic module generates various tactile effects that a user may feel. The haptic module may provide a user with vibration as a tactile effect. The intensity, pattern, and the like of vibration generated by the haptic module may be controlled according to a user's selection or settings of the main processor. For example, the haptic module may synthesize different vibrations and output a result of the synthesis, or may sequentially output the different vibrations. The haptic module may generate, in addition to vibrations, various other tactile effects such as an effect due to a pin arrangement vertically moving with respect to a skin surface, a jet force or suction force of the air through a nozzle or inlet, grazing of the skin surface, a contact of an electrode, and a stimulus such as an electrostatic force, and an effect due to reproduction of cold and warmth senses by using an element capable of heat absorption and heat emission. The haptic module may transmit a tactile effect through direct contact, and may also be implemented such that a user may feel a tactile effect through a muscle sense such as in a finger or an arm.

The optical output unit outputs a signal for notifying occurrence of an event, by using the light of a light source. Examples of the event generated in the electronic device 1 may include message reception, call signal reception, a missed call, an alarm, schedule notification, e-mail reception, and information reception through an application. The signal output by the optical output unit is implemented as the electronic device 1 emits light of a single color or light beams of a plurality of colors to its front surface or rear surface. The outputting of the signal may be terminated when the electronic device 1 senses that a user confirms an event.

The interface unit serves as a passage with various types of external apparatuses that are connected to the electronic device 1. The interface unit may include at least one of a wired/wireless headset port, an external charger port, a wired/wireless data port, a memory card port, a port connecting a device including an identification module, an audio input/output (I/O) port, a video I/O port, and an earphone port. In an example in which an external apparatus is connected to the interface unit, the electronic device 1 may perform an appropriate control related with the connected external apparatus.

The memory stores data that supports various functions of the electronic device 1. The memory may store a plurality of application programs driven by the electronic device 1, pieces of data for operations of the electronic device 1, and instructions. At least some of the plurality of application programs may be downloaded from an external server through wireless communication. The memory may store an application for an operation of the main processor, and may temporarily store input/output data, for example, a phone book, a message, a still image, and a moving picture. The memory may also store haptic data for various patterns of vibration that are provided to the haptic module, and audio data about various sounds that are provided to the audio output unit. The memory may include at least one type of storage medium selected from among a flash memory type, a hard disk type, a solid state disk (SSD) type, a silicon disk drive (SDD) type, a multimedia card micro type, a card type memory (for example, a secure digital (SD) or extreme digital (XD) memory), a random access memory (RAM), a static random access memory (SRAM), a read-only memory (ROM), an electrically erasable programmable ROM (EEPROM), a programmable ROM (PROM), magnetic memory, a magnetic disk, and an optical disk.

Under a control by the main processor, the power supplier may receive external power and internal power and supply the external and internal power to the components included in the electronic device 1. The power supplier may include a battery. The power supplier includes a connection port that may be an example of the interface unit to which an external charger supplying power to charge a battery is electrically connected. Alternatively, the power supplier may be configured to charge the battery in a wireless manner without using a connection port. The battery may receive power from an external wireless power transmission device by using at least one of an inductive coupling method based on a magnetic induction phenomenon or a magnetic resonance coupling method based on an electromagnetic resonance phenomenon. The battery may be arranged to not overlap the main circuit board in the third direction (e.g., a z-axis direction).

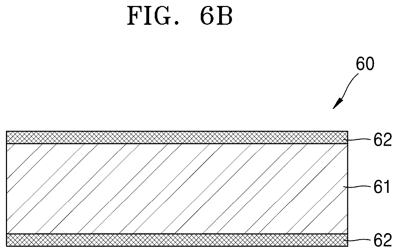

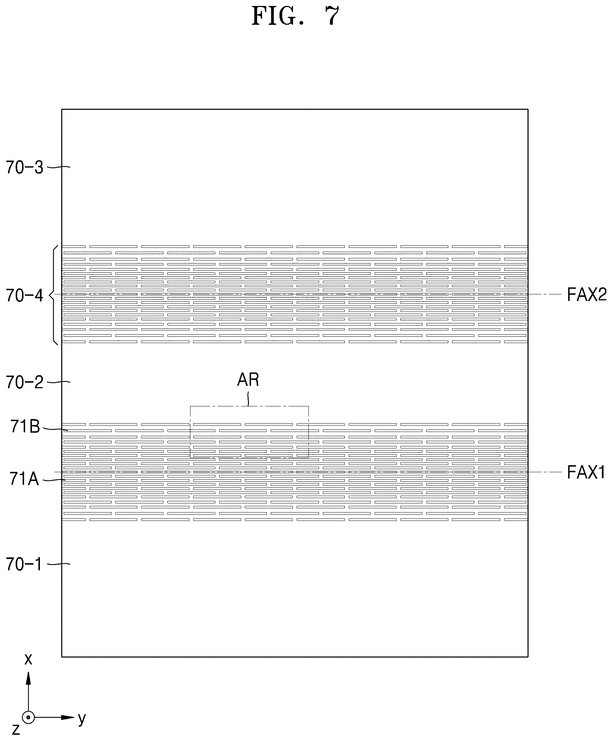

FIG. 6A is a schematic cross-sectional view of a portion of the electronic device 1 of FIG. 5A. FIG. 6A is a cross-sectional view taken along line A-A' in FIG. 5A. FIG. 6B is a schematic cross-sectional view of a reinforcing member 60 illustrated in FIG. 6A. FIG. 7 is a schematic plan view of a support plate 70 illustrated in FIG. 6A.

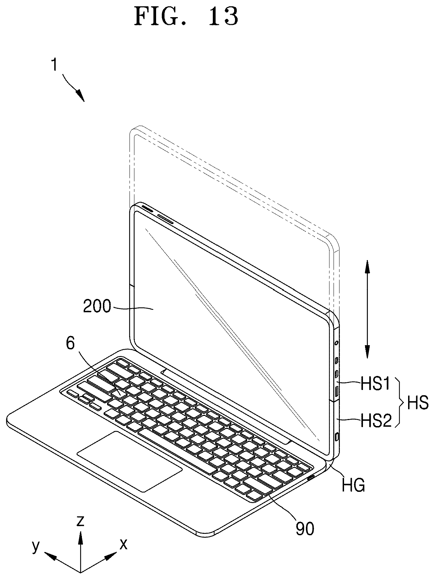

Referring to FIGS. 6A through 7, the display apparatus 200(see FIG. 13) may include an anti-reflection layer PF, a cover member 10, a data driver 20, a display circuit board 30, a panel protective member PFI, a functional layer 42, a display panel 50, a reinforcing member 60, a support plate 70, a first adhesive member 81, a second adhesive member 82, a third adhesive member 83, a fourth adhesive member 84, and a fifth adhesive member 85.

The anti-reflection layer PF may be disposed on the cover member 10. The anti-reflection layer PF may be included as a polarization film. The polarization film may include a linear polarization plate and a phase delay film such as a quarter-wave (λ/4) plate. The phase delay film may be disposed on the cover member 10, and the linear polarization plate may be disposed on the phase delay film.

According to an embodiment, the anti-reflection layer PF may include a destructive interference structure. The destructive interference structure may include a first reflective layer and a second reflective layer arranged on different layers. First reflected light and second reflected light respectively reflected by the first reflective layer and the second reflective layer may destructively interfere with each other, and thus the reflectance of external light may be reduced.

The cover member 10 may be disposed over the display panel 50. According to an embodiment, the cover member 10 may cover an upper portion of the display panel 50. Thus, the cover member 10 may function to protect an upper surface of the display panel 50.

Although not illustrated in the drawings, according to an embodiment, the cover member 10 may include a transmission cover unit corresponding to the display panel 50, and a light-blocking cover unit corresponding to an area other than the display panel 50. The light-blocking cover unit may include an opaque material that blocks light. The light-blocking cover unit may include a pattern that may be visible to a user when no images are displayed.

According to an embodiment, the cover member 10 may include at least one layer. For example, the at least one layer may include glass, a transparent synthetic resin, or the like.

The cover member 10 may include a light-blocking layer 10A arranged on one surface thereof. According to an embodiment, the light-blocking layer 10A may be disposed on an edge of the cover member 10. The light-blocking layer 10A may include a black ink. Although not illustrated in the drawings, the light blocking layer 10A may be disposed so as to be inserted into the interior of the cover member 10 in addition to being disposed on one surface of the cover member 10. In this case, the cover member 10 may include at least two layers, and the light-blocking layer 10A may be disposed between the at least two layers.

The second adhesive member 82 may be disposed on the cover member 10. The second adhesive member 82 may be a transparent adhesive member, such as a pressure sensitive adhesive (PSA) or optically clear adhesive (OCA) film. The second adhesive member 82 may fix the cover member 10 to the anti-reflection layer PF.

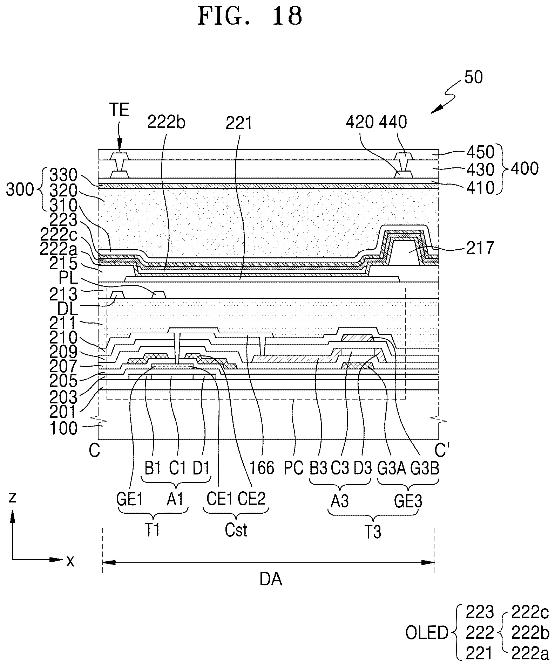

The display panel 50 may be disposed under the cover member 10. The display panel 50 may be connected to a display circuit board 30. Although not illustrated in the drawings, embodiments of the present disclosure support implementations in which a touch sensor driver and a data driver 20 are arranged on the display circuit board 30. According to another embodiment, the data driver 20 may be disposed directly on a substrate 100 of the display panel 50 as illustrated in the drawings, and the touch sensor driver may be disposed on the display circuit board 30. At least a first portion of the substrate 100 (see FIG. 18) of the display panel 50 as described herein may be bent (e.g., be selectively bent). At this time, a bending protective layer BPL may be disposed on the bent portion of the substrate 100 in order to prevent cracks or the like in the substrate 100. The bending protective layer BPL may include a polymer resin, such as polyethylene terephthalate (PET), polyimide (PI), or the like

The bending protective layer BPL may be disposed to shield a bending area of the display panel 50.

According to an embodiment, the functional layer 42 may be disposed on the display panel 50, and a protective member PFI may be disposed below the display panel 50. In this case, the functional layer 42 may be disposed between the cover member 10 and the display panel 50. An upper portion of the display panel 50 may include a touch screen layer that receives a touch signal from a user.

According to an embodiment, the functional layer 42 may include a shock absorbing layer. In this case, the shock absorbing layer may function to protect a structure, such as the display panel 50 below the shock absorbing layer, from an external shock. According to an embodiment, the shock absorbing layer may be a polymer film. The polymer film may include at least one of, for example, Polyethylene Terephthalate (PET), Polyethylene Naphthalate (PEN), Polyether Sulfone (PES), Polyimide (PI), Polyarylate (PAR), Polycarbonate (PC), Polymethyl Methacrylate (PMMA), or Cyclic Olefin Copolymer (COC) resin.

According to an embodiment, the functional layer 42 may include a touch sensor layer and a shock absorbing layer. In this case, an anti-reflection layer and the shock absorbing layer may be sequentially stacked on the display panel 50.

The functional layer 42 may determine a location of an end of the bending protective layer BPL. That is, when the bending protective layer BPL is formed, the bending protective layer BPL may be formed in a resin form and supplied onto the substrate 100 of the display panel 50. In this case, because the bending protective layer BPL is fluid, the bending protective layer BPL is not located at a fixed position on the display panel 50 but may move in various directions on the display panel 50. However, when the functional layer 42 is disposed on the display panel 50, an end of the functional layer 42 may prevent the bending protective layer BPL from flowing into an area of the display panel 50 where the functional layer 42 is disposed, and may also limit the area into which the bending protective layer BPL flows. Therefore, the bending protective layer BPL may be disposed in the peripheral area PA of the display panel 50, without being disposed in the display area DA.

The functional layer 42 may be disposed directly on the display panel 50. According to another embodiment, a separate adhesive member may be disposed between the functional layer 42 and the display panel 50. In this case, the adhesive member may be a transparent adhesive member, such as a PSA or OCA film.

The cover member 10 may be disposed over the functional layer 42. The cover member 10 may be attached onto the functional layer 42 by the first adhesive member 81. According to an embodiment, the first adhesive member 81 may be a transparent adhesive member, such as a PSA or OCA film.

According to an embodiment, the protective member PFI may be disposed below the display panel 50. In this case, the protective member PFI may absorb an impact applied from the outside of the display apparatus 200. In this case, an opening area PFI_OP may be arranged in the protective member PFI to correspond to the bending area of the display panel 50 that is to be described later. In this case, a width of the opening area PFI_OP may be less than a width of the bending area. The protective member PFI may include a polymer material. Although not illustrated in the drawings, an adhesive material may be disposed between the protective member PFI and the display panel 50. In this case, the adhesive member may be a transparent adhesive member, such as a PSA or OCA film.

According to an embodiment, the reinforcing member 60 may be disposed below the protective member PFI to support the display panel 50.

According to an embodiment, the reinforcing member 60 may include a core layer 61 and outer layers 62. The outer layers 62 may be arranged on both lateral surfaces of the core layer 61. The core layer 61 may include polyethylene terephthalate (PET), polyethylene naphthalate (PEN), and/or colorless PI. The outer layers 62 may include a resin (such as, acryl, urethane, or epoxy) and a carbon black-based pigment, and may block external light or reflected light.

According to an embodiment, the reinforcing member 60 may be attached to the protective member PFI via the third adhesive member 83. According to an embodiment, the third adhesive member 83 may be a transparent adhesive member, such as a pressure sensitive adhesive (PSA) or an optically clear adhesive (OCA) film.

According to an embodiment, the reinforcing member 60 and the support plate 70 may be adhered to each other by the fourth adhesive member 84. According to an embodiment, the fourth adhesive member 84 may be a PSA, an OCA film, or a thermoplastic polyurethane (TPU).

According to an embodiment, the fourth adhesive member 84 may be located below the reinforcing member 60.

According to an embodiment, the support plate 70 may be disposed under the display panel 50. The support plate 70 may include metal, plastic (such as, polyurethane), carbon fiber reinforced plastic (CFRP), and/or graphite.

The support plate 70 according to an embodiment may include a first portion 70-1, a second portion 70-2, a third portion 70-3, and a fourth portion 70-4. According to an embodiment, the first portion 70-1 of the support plate 70 may at least partially overlap the first display area DA1, and the second portion 70-2 of the support plate 70 may at least partially overlap the second display area DA2. The third portion 70-3 of the support plate 70 may at least partially overlap the third display area DA3. The fourth portion 70-4 disposed between the first portion 70-1 and the second portion 70-2 of the support plate 70 may at least partially overlap the first folding area FA1, and the fourth portion 70-4 disposed between the second portion 70-2 and the third portion 70-3 of the support plate 70 may at least partially overlap the second folding area FA2.

According to an embodiment, the first portion 70-1 and the second portion 70-2 of the support plate 70 may be spaced apart from each other in a second direction (e.g., an x direction) with the first folding axis FAX1 between the first portion 70-1 and the second portion 70-2. The second portion 70-2 and the third portion 70-3 of the support plate 70 may be spaced apart from each other in the second direction (e.g., the x-axis direction) with the second folding axis FAX2 between the second portion 70-2 and the third portion 70-3. The fourth portions 70-4 may connect the first portion 70-1 to the second portion 70-2, and may connect the second portion 70-2 to the third portion 70-3. In this case, each of the fourth portions 70-4 may be a variable region that is deformed when the display panel 50 is folded along the first folding axis FAX1 or the second folding axis FAX2. A plurality of opening patterns 71 arranged apart from each other may help the fourth portions 70-4 corresponding to the first folding axis FAX1 and/or the second folding axis FAX2 to be smoothly deformed when the support plate 70 is deformed.

The fourth portions 70-4, which are variable regions, may include a first pattern region 70-4A (also being referred to as a first region) in which a first opening pattern 71A is arranged and a second pattern region 70-4B (also being referred to as a second region) in which a second opening pattern 71B is arranged. The first opening pattern 71A and the second opening pattern 71B may be arranged apart from each other. In this case, the first opening pattern 71A and the second opening pattern 71B may each be formed in a long hole shape in a direction perpendicular to a lengthwise direction of the display panel 50 of FIG. 5A. That is, the first opening pattern 71A and the second opening pattern 71B may each have a rectangular shape with a length and a width, and may have rounded corners. A length of the first opening pattern 71A may be greater than a width of the first opening pattern 71A, and a length of the second opening pattern 71B may be greater than a width of the second opening pattern 71B. In this case, the length may be measured in the y-axis direction of FIG. 7, and the width may be measured in the x-axis direction of FIG. 7. In some embodiments, the first opening pattern 71A may be arranged to correspond to a first portion of the substrate 100 (see FIG. 18), and the second opening pattern 71B may be arranged to correspond to a second portion of the substrate 100. In some embodiments, the second pattern region 70-4B may be connected to first pattern region 70-4A.

The first pattern region 70-4A and the second pattern region 70-4B may be arranged symmetrically with respect to the first folding axis FAX1 or the second folding axis FAX2. That is, based on the first folding axis FAX1 or the second folding axis FAX2, the first pattern region 70-4A may be adjacent to the first folding axis FAX1 or the second folding axis FAX2, and the first pattern region 70-4A may be arranged between the first folding axis FAX1 and the second pattern region 70-4B or between the second folding axis FAX2 and the second pattern region 70-4B. In this case, the first pattern region 70-4A may be disposed on both sides of the first folding axis FAX1 or the second folding axis FAX2, based on the first folding axis FAX1 or the second folding axis FAX2.

The support plate 70 may include recessed portions 75 arranged on both ends of the fourth portion 70-4. The recessed portions 75 may be in the form of a groove recessed from a lower surface of the support plate 70. The recessed portions 75 may accommodate deformation of the support plate 70 at a point where curvature of the support plate 70 changes when the support plate 70 is folded together with the display panel 50.

The fourth adhesive member 84 may be disposed between the support plate 70 and the reinforcing member 60. The fourth adhesive member 84 may be a PSA, an OCA film, or a thermoplastic Polyurethane (TPU).

The fourth adhesive member 84 may include an opening 84A corresponding to the fourth portion 70-4. In this case, the fourth adhesive member 84 may reduce interference with a movement of the support plate 70 or the reinforcing member 60 when being folded through the opening 84A. The opening 84A may have a hole or groove shape.

The display circuit board 30 may be fixed to the support plate 70 via the fifth adhesive member 85. Although not illustrated in the drawings, a bracket in which the display apparatus 200 may be accommodated may be disposed between the display circuit board 30 and the support plate 70, and the display circuit board 30 may be also fixed to a rear surface of this bracket. The fifth adhesive member 85 may be a PSA, an OCA film, or a TPU.

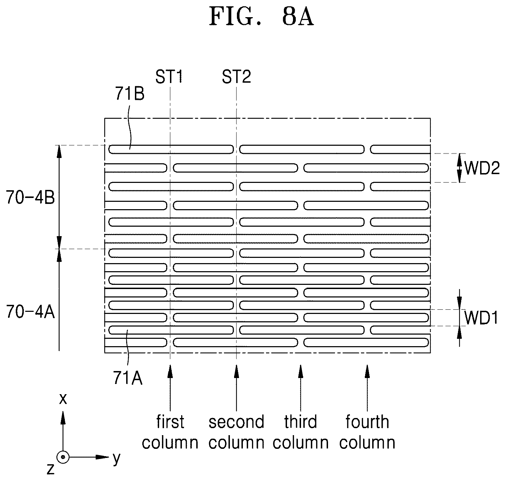

FIG. 8A is a schematic plan view of an area AR illustrated in FIG. 7.

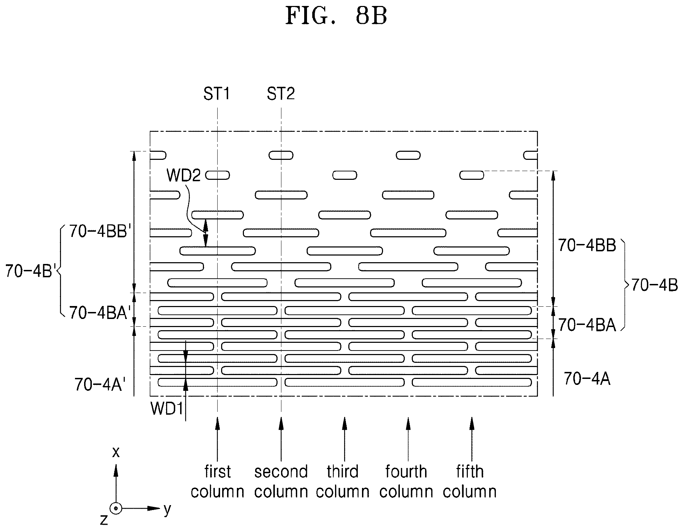

Referring to FIG. 8A, the fourth portion 70-4 may include a plurality of opening patterns. Some of the plurality of opening patterns may be arranged in a column, and may form one opening pattern group. The centers of a plurality of opening patterns arranged in an opening pattern group may be arranged on a straight line parallel to the second direction (e.g., the x-axis direction of FIGS. 8A and 8B, a width direction of an opening pattern, or a direction perpendicular to a folding axis). The fourth portion 70-4 may include a plurality of opening pattern groups. For example, opening pattern groups may be arranged in first, second, third, and fourth columns, respectively, as illustrated in FIG. 8A. In this case, opening pattern groups arranged in different columns may overlap each other in the second direction. For example, the opening pattern group arranged in the first column and the opening pattern group arranged in the second column may overlap each other in the second direction, the opening pattern group arranged in the second column and the opening pattern group arranged in the third column may overlap each other in the second direction, and the opening pattern group arranged in the third column and the opening pattern group arranged in the fourth column may overlap each other in the second direction. In this case, an opening pattern arranged in one of adjacent opening pattern groups may be arranged between opening patterns arranged in the other of the adjacent opening pattern groups.

The centers of the opening patterns arranged in each opening pattern group may be arranged on any straight line parallel to the second direction. For example, the centers of the opening patterns arranged in the opening pattern group arranged in the first column may be arranged on a first straight line ST1, and the centers of the opening patterns arranged in the opening pattern group arranged in the second column may be arranged on a second straight line ST2.

Each opening pattern group may include the first pattern region 70-4A and the second pattern region 70-4B.

The first pattern region 70-4A may include first opening patterns 71A arranged apart from each other in the second direction. The second pattern region 70-4B may include second opening patterns 71B arranged apart from each other in the second direction.

The first opening patterns 71A and the second opening patterns 71B may be the same as each other. In other words, the length of the first opening pattern 71A may be the same as the length of the second opening pattern 71B, and the width of the first opening pattern 71A may be the same as the width of the second opening pattern 71B.

First intervals WD1 between first opening patterns 71A adjacent to each other in the second direction, which is the width direction of the first opening pattern 71A, are all equal to each other in the first pattern region 70-4A, and an interval between first opening patterns 71A adjacent to each other in the first direction (for example, the y-axis direction of FIG. 8A, a lengthwise direction of an opening pattern, or a direction parallel to a folding axis) different from the second direction may be all equal to each other in the first pattern region 70-4A. In this case, the first direction may be the lengthwise direction of the first opening pattern 71A and the second opening pattern 71B.

A second interval WD2 between second opening patterns 71B adjacent to each other in the second direction may vary. For example, the second interval WD2 may increase in a direction away from the first pattern region 70-4A. In this case, second intervals WD2 may sequentially increase by a certain value in a direction away from the first pattern region 70-4A. In an example in which the certain value by which the second interval WD2 increases is 5 µm, the first interval WD1 is 100 µm, and six second opening patterns 71B are arranged in the second pattern region 70-4B, a first second interval WD2 may be 105 µm. In an example in which second intervals WD2 sequentially increase by5 µm, a second second interval WD2 may be 110 µm, a third second interval WD2 may be 115 µm, a fourth second interval WD2 may be 120 µm, and a fifth second interval WD2 may be 125 µm.

In such a case, a second interval between second opening patterns 71B arranged at an outermost edge of the second pattern region 70-4B among the second intervals WD2 may be largest in the second pattern region 70-4B. In this case, a maximum value among the second intervals WD2 may be 1 mm or less. In some embodiments, the second intervals WD2 may range from 5 µm to 1 mm. In an example in which the maximum value among the second intervals WD2 exceeds 1 mm, flatness of the display panel 50 changes rapidly at a portion corresponding to the outermost edge of the second pattern region 70-4B, such that a point where the flatness of the display panel 50 changes may be recognized from the outside.

At least some of first opening patterns 71A and second opening patterns 71B arranged in different columns may overlap each other. In this case, an area by which a first opening pattern 71A and a second opening pattern 71B arranged in different columns overlap each other in the second direction may be less than about 50% of the area of either the first opening pattern 71A or the second opening pattern 71B. For example, an overlapping length of the first opening pattern 71A or an overlapping length of the second opening pattern 71B when the first opening pattern 71A arranged in the first column and the second opening pattern 71B arranged in the second column overlap each other in the second direction may be less than about 50% of the length of either the first opening pattern 71A or the second opening pattern 71B. In this case, when an area of the first opening pattern 71A or the second opening pattern 71B by which the first opening pattern 71A and the second opening pattern 71B overlap each other in the second direction is 50% or more, the rigidity of the support plate 70 may be reduced or the display panel 50 may not be supported by the fourth portion 70-4. In some embodiments, first opening patterns 71A adjacent to each other in the first direction (e.g., y-axis direction of FIG. 8A) may overlap each other at least partially in a second direction (e.g., x-axis direction of FIG. 8A); and/or second opening patterns 71B adjacent to each other in the first direction may overlap each other at least partially in the second direction.

When an interval between second opening patterns 71B increases, the curvature of a surface of the display panel 50 disposed on the support plate 70 at an outermost edge of the fourth portion 70-4 may be reduced. Accordingly, visual recognition of the second opening pattern 71B at the outermost edge of the fourth portion 70-4 or visual recognition of the curvature of the surface of the display panel 50 may be reduced.

In such a case, the area of the second pattern region 70-4B may be about 5% to about 40% of a sum of the area of the first pattern region 70-4A and the area of the second pattern region 70-4B. In an example in which an amount by which the second interval WD2 between the second opening patterns 71B spaced apart from each other in the second pattern region 70-4B increases is 10 µm or less, the area of the second pattern region 70-4B may be about 5% to about 40% of a sum of the area of the first pattern region 70-4A and the area of the second pattern region 70-4B. According to another embodiment, when an amount by which the second interval WD2 increases is 10 µm or less, the area of the second pattern region 70-4B may be about 5% to about 20% of a sum of the area of the first pattern region 70-4A and the area of the second pattern region 70-4B. In this case, when occupancy of the second pattern region 70-4B in the sum of the first pattern region 70-4A and the second pattern region 70-4B is too large (e.g., above a threshold occupancy amount), deformation of the support plate 70 may be hindered, and, when the occupancy of the second pattern region 70-4B in the sum of the first pattern region 70-4A and the second pattern region 70-4B is too small (e.g., below a threshold occupancy amount), the surface of the support plate 70 at the outermost edge of the second pattern region 70-4B may be bent.

FIG. 8B is a schematic plan view of the area AR illustrated in FIG. 7.

Referring to FIG. 8B, each opening pattern group of the fourth portion 70-4 may include a first pattern region 70-4A including a plurality of first opening patterns 71A, which correspond to a first group, and a second pattern region 70-4B including a plurality of second opening patterns 71B, which correspond to a second group. In this case, the first opening patterns 71A and the first pattern region 70-4A are the same as or similar to those described herein with reference to FIG. 8A, and thus detailed descriptions thereof are omitted herein.

The second intervals WD2 between second opening patterns 71B adjacent to each other in the second direction may sequentially increase. The second pattern region 70-4B may be disposed such that the plurality of second opening patterns 71B may be spaced apart from each other. In this case, the second pattern region 70-4B may include a 2-1 pattern region 70-4BA in which second opening patterns 71B (e.g., a first subgroup of opening patterns) having the same sizes (e.g., the same lengths and the same widths) as the first opening patterns 71A (i.e., having constant lengths) and having the second interval WD2 different from the first interval WD1 are arranged, and a 2-2 pattern region 70-4BB in which second opening patterns 71B (e.g., a second subgroup of opening patterns) having different sizes than the first opening patterns 71A and having the second interval WD2 different from the first interval WD1 are arranged.

In the above case, widths of the second opening patterns 71B arranged in the 2-2 pattern region 70-4BB may be the same as widths of the first opening patterns 71A, and lengths of the second opening patterns 71B arranged in the 2-2 pattern region 70-4BB may be different from lengths of the first opening patterns 71A. For example, the lengths of the second opening patterns 71B arranged in the 2-2 pattern region 70-4BB may be less than the lengths of the first opening patterns 71A. The lengths of the second opening patterns 71B arranged in the 2-2 pattern region 70-4BB may sequentially decrease in a direction away from the first pattern region 70-4A or the 2-1 pattern region 70-4BA. That is, lengths of second opening patterns 71B arranged at the outermost edge of the second pattern region 70-4B and being farthest from the first pattern region 70-4A may be the smallest among the respective lengths of the plurality of second opening patterns 71B arranged in the second pattern region 70-4B. In this case, the lengths of the second opening patterns 71B arranged in the 2-2 pattern region 70-4BB may decrease by a certain value in the second direction from the lengths of the second opening patterns 71B arranged in the 2-1 pattern region 70-4BA. In an example in which a length of one second opening pattern 71B arranged in the 2-2 pattern region 70-4BB is 1000 µm, a length of another second opening pattern 71B spaced apart from the one second opening pattern 71B in the second direction may be 950 µm. A length of another second opening pattern 71B spaced apart from the other second opening pattern 71B in the second direction may be 900 µm. That is, the lengths of the second opening patterns 71B included in the 2-2 pattern region 70-4BB may decrease by 50 µm at a time away from the 2-1 pattern region 70-4BA in the second direction. In the above case, ends of the second opening patterns 71B arranged in the 2-2 pattern region 70-4BB may be arranged on a straight line in the 2-2 pattern region 70-4BB. In this case, the straight line may be diagonal with respect to the second direction.

Some of the plurality of second opening patterns 71B as described herein may be arranged in one column, and other some of the plurality of second opening patterns 71B may be arranged in another column adjacent to the one column. In this case, centers of a plurality of second opening patterns 71B arranged in the same column may be arranged on any first straight line ST1 parallel to the second direction.

Some of the plurality of second opening patterns 71B arranged in the one column and the other some of the plurality of second opening patterns 71B arranged in the other column may be arranged to be overlapped with each other in the second direction. Accordingly, reduction of the strength of the fourth portion may be reduced, and also may not interfere with deformation of the fourth portion.

For example, the centers of a plurality of first opening patterns 71A and the centers of a plurality of second opening patterns 71B arranged in another columns may be arranged on a second straight line ST2 parallel to the first straight line ST1. A plurality of first opening patterns 71A arranged on the second straight line ST2 may form another first region 70-4A', which is a third group, and a plurality of second opening patterns 71B arranged on the second straight line ST2 may form another second pattern region 70-4B', which is a fourth group. In this case, the other first pattern region 70-4A' may be similar to the first pattern region 70-4A.

The other second pattern region 70-4B' may include another 2-1 pattern region 70-4BA' in which second opening patterns 71B having the same sizes and having different second intervals WD2 in the second direction are arranged, and another 2-2 pattern region 70-4BB' in which second opening patterns 71B having different sizes and having different second intervals WD2 in the second direction are arranged. In this case, the second opening patterns 71B included in the other 2-1 pattern region 70-4BA' may be arranged to be overlapped with respect to the second opening patterns 71B included in the 2-1 pattern region 70-4BA. At least one of the second opening patterns 71B included in the other 2-2 pattern region 70-4BB' may be arranged to be overlapped with respect to at least one of the second opening patterns 71B included in the 2-2 pattern region 70-4BB. In this case, at least another of the second opening patterns 71B included in the other 2-2 pattern region 70-4BB' may not overlap at least another of the second opening patterns 71B included in the 2-2 pattern region 70-4BB.

In the above case, in the fourth portion 70-4, an opening pattern centered on the first straight line ST1 and an opening pattern centered on the second straight line ST2 may be arranged alternately in the first direction. In this case, a space between adjacent opening patterns may be shielded by at least one of opening patterns in another column arranged between the adjacent opening patterns. For example, in FIG. 8B, at least one of the first opening patterns 71A or the second opening patterns 71B arranged in the second column may be arranged between the first opening patterns 71A arranged in the first and third columns and between some of the second opening patterns 71B arranged in the first and third columns. In this case, the second straight line ST2 may pass through a center of the opening patterns in the second column arranged between the first and third columns.

In the above case, the area of the second pattern region 70-4B may be the same as that described herein with reference to FIG. 8A.

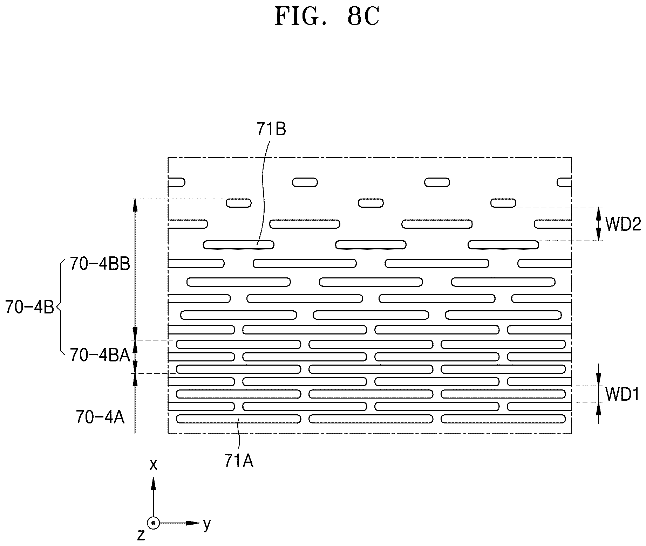

FIG. 8C is a schematic plan view of the area AR illustrated in FIG. 7.

Referring to FIG. 8C, each opening pattern group of the fourth portion 70-4 may include a first pattern region 70-4A including a plurality of first opening patterns 71A, which correspond to a first group, and a second pattern region 70-4B including a plurality of second opening patterns 71B, which correspond to a second group. In this case, the first opening patterns 71A and the first pattern region 70-4A are the same as or similar to those described herein with reference to FIG. 8A, and thus detailed descriptions thereof are omitted herein.

The second intervals WD2 between second opening patterns 71B adjacent to each other in the second direction may sequentially increase. The second pattern region 70-4B may be disposed such that the plurality of second opening patterns 71B may be spaced apart from each other. In this case, the second pattern region 70-4B may include a 2-1 pattern region 70-4BA in which second opening patterns 71B having the same sizes (e.g., the same lengths and the same widths) as the first opening patterns 71A and having the second interval WD2 different from the first interval WD1 are arranged, and a 2-2 pattern region 70-4BB in which second opening patterns 71B having different sizes than the first opening patterns 71A and having the second interval WD2 different from the first interval WD1 are arranged. In this case, shapes of the second opening patterns 71B arranged in the 2-1 pattern region 70-4BA and the 2-2 pattern region 70-4BB are similar to those described herein with reference to FIG. 8B, so a detailed description thereof will be omitted. In the above case, ends of the second opening patterns 71B arranged in the 2-2 pattern region 70-4BB may form curved lines.

In the above case, the area of the second pattern region 70-4B may be the same as that described herein with reference to FIG. 8A. In some aspects, the centers of the first opening patterns 71A and the second opening patterns 71B may be arranged on the same straight line as illustrated in FIG. 8A or FIG. 8B.

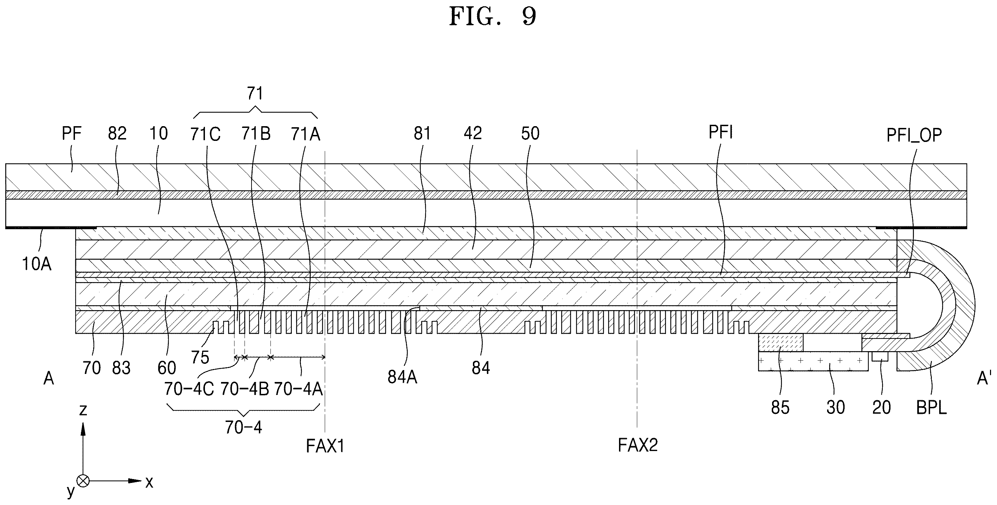

FIG. 9 is a schematic cross-sectional view of a portion of the electronic device 1 of FIG. 5A. FIG. 9 is a cross-sectional view taken along line A-A' in FIG. 5A.

Referring to FIG. 9, the display apparatus 200 (see FIG. 13) may include an anti-reflection layer PF, a cover member 10, a data driver 20, a display circuit board 30, a panel protective member PFI, a functional layer 42, a display panel 50, a reinforcing member 60, a support plate 70, a first adhesive member 81, a second adhesive member 82, a third adhesive member 83, a fourth adhesive member 84, and a fifth adhesive member 85. In this case, the anti-reflection layer PF, the cover member 10, the data driver 20, the display circuit board 30, the panel protective member PFI, the functional layer 42, the display panel 50, the reinforcing member 60, the first adhesive member 81, the second adhesive member 82, the third adhesive member 83, the fourth adhesive member 84, and the fifth adhesive member 85 are the same as or similar to those described herein with reference to FIG. 6A, so detailed descriptions thereof will be omitted.

The support plate 70 may include a first portion 70-1, a second portion 70-2, a third portion 70-3, and a fourth portion 70-4. In this case, the first portion 70-1, the second portion 70-2, and the third portion 70-3 may be the same as or similar to those described herein with reference to FIGS. 6A and 7.

The fourth portion 70-4 may overlap at least a portion of at least one of the first folding area FA1 and the second folding area FA2 illustrated in FIG. 5A. The fourth portion 70-4 may include a first pattern region 70-4A, a second pattern region 70-4B, and a third pattern region (also being referred to as a third region) 70-4C. In some embodiments, the first pattern region 70-4A, the second pattern region 70-4B, and the third pattern region 70-4C may be arranged sequentially from one end of the lower cover 90 (see FIG. 5A) to another end of the lower cover 90. In this case, the first pattern region 70-4A and the second pattern region 70-4B may be the same as or similar to those described herein with reference to FIG. 6A.

The third pattern region 70-4C may extend from the second pattern region 70-4B and may be disposed at an outermost edge of the fourth portion 70-4. In this case, the third pattern region 70-4C may be disposed at the outermost edge of the fourth portion 70-4 to disperse the stress applied to the support plate 70 when the electronic device 1 is folded. Accordingly, one side of the support plate 70 may be maintained flat, and the curvature of a surface of the display panel 50 on the support plate 70 may be reduced. A recessed portion 75 may be disposed around the third pattern region 70-4C as described herein. In some embodiments, the third pattern region 70-4C may be connected to the second pattern region 70-4B.

The fourth portion 70-4 may be disposed such that its left and right sides are symmetrical with each other about the first folding axis FAX1 or the second folding axis FAX2. That is, the first pattern region 70-4A may be disposed on the first folding axis FAX1 or the second folding axis FAX2, the second pattern regions 70-4B may be arranged on both sides of the first pattern region 70-4A, and the third pattern region 70-4C may be disposed outside the second pattern region 70-4B.

In the above case, the fourth adhesive member 84 may include an opening 84A disposed at a portion of the fourth adhesive member 84 that corresponds to the fourth portion 70-4. The opening 84A may overlap not only the first pattern region 70-4A and the second pattern region 70-4B but also the third pattern region 70-4C.

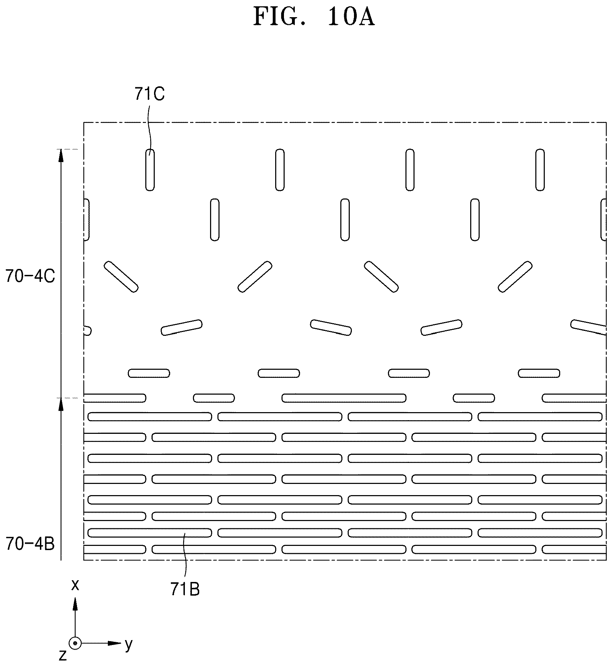

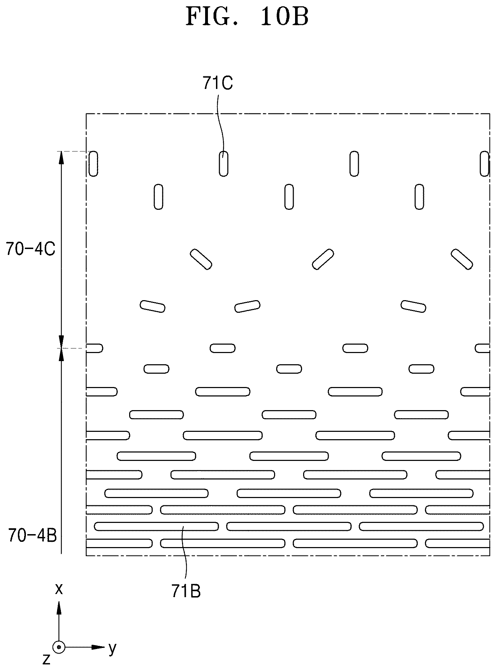

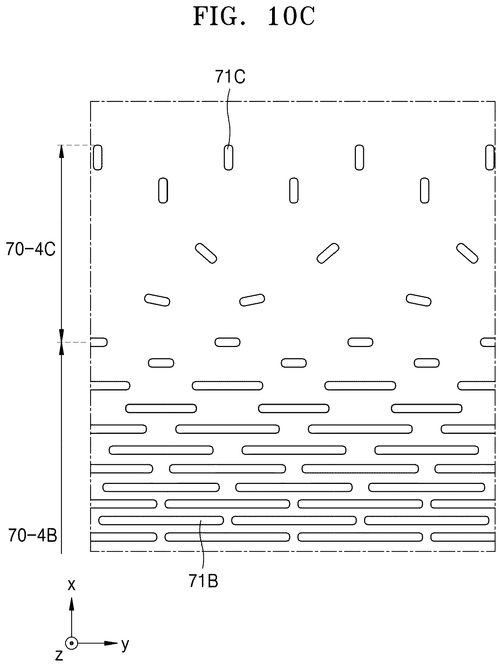

FIGS. 10A through 10C are schematic plan views of a portion of a variable region illustrated in FIG. 9.

Referring to FIGS. 10A through 10C, the fourth portion 70-4 may include a first pattern region, a second pattern region 70-4B, and a third pattern region 70-4C. The first pattern region and the second pattern region 70-4B are the same as those described herein with reference to FIGS. 8A through 8C, and thus detailed descriptions thereof are omitted herein. Although not illustrated in the drawings, the first pattern region may be disposed below the second pattern region 70-4B as described herein with reference to FIGS. 8A through 8C.

In the above case, the third pattern region 70-4C may extend from the second pattern region 70-4B. The third pattern region 70-4C may include a plurality of third opening patterns 71C arranged in various directions. In some embodiments, the third opening patterns 71C may be arranged to correspond to a third portion of the substrate 100 (see FIG. 18). In some embodiments, similar to the first opening pattern 71A and the second opening pattern 71B, the third opening patterns 71C may have a rectangular shape with a length and a width, and may have rounded corners. A length of the third opening patterns 71C may be greater than a width of the third opening patterns 71C. One of the plurality of third opening patterns 71C may be arranged in a different direction from another one of the plurality of third opening patterns 71C. For example, a lengthwise direction of one of the plurality of third opening patterns 71C closest to the second pattern region 70-4B may have a smaller angle with respect to a lengthwise direction of a first opening pattern 71A or a lengthwise direction of a second opening pattern 71B than a lengthwise direction of another one of the plurality of third opening patterns 71C arranged at a farthest position from the second pattern region 70-4B. That is, an angle formed by the lengthwise direction of the third opening pattern 71C arranged in the third pattern region 70-4C and the lengthwise direction of the first opening pattern 71A or the lengthwise direction of the second opening pattern 71B may increase in a direction away from the second pattern region 70-4B. In this case, the angle may refer to an angle of 90° (degrees) or less among the angles formed by the lengthwise direction of the first opening pattern 71A or the lengthwise direction of the second opening pattern 71B and the lengthwise direction of the third opening pattern 71C when the center of the first opening pattern 71A or the center of the second opening pattern 71B coincides with the center of the third opening pattern 71C. Lengthwise directions of the plurality of third opening patterns 71C may become closer to being perpendicular to the lengthwise direction of the first opening pattern 71A or the lengthwise direction of the second opening pattern 71B in a direction from one of the plurality of third opening patterns 71C closest to the second pattern region 70-4B to another one of the plurality of third opening patterns 71C arranged at a farthest position from the second pattern region 70-4B. That is, a lengthwise direction of a third opening pattern 71C arranged at an outermost edge of the third pattern region 70-4C may be perpendicular to the lengthwise direction of the first opening pattern 71A or the lengthwise direction of the second opening pattern 71B.

In the above case, the plurality of third opening patterns 71C may have a radially spreading configuration. The third opening pattern 71C arranged at the outermost edge of the third pattern region 70-4C that is farthest in the second direction from the second pattern region 70-4B may be arranged on the first straight line ST1 or the second straight line ST2 illustrated in FIG. 8A or FIG. 8B.

The plurality of third opening patterns 71C may be arranged in various directions to disperse the stress generated in the support plate 70 at an end of the fourth portion 70-4, thereby reducing deformation of the support plate 70. In some aspects, the plurality of third opening patterns 71C may reduce a sudden change in strength of the support plate 70 at an outermost edge portion of the second pattern region 70-4B.

The area of the third pattern region 70-4C as described herein may be (approximately) 10% or less of a sum of all of the areas of the first pattern region, the second pattern region 70-4B, and the third pattern region 70-4C, and may also exceed 0%. In this case, when the area of the third pattern region 70-4C exceeds 10% of the sum of all of the areas of the first pattern region, the second pattern region 70-4B, and the third pattern region 70-4C, the support plate 70 may be distorted in the third pattern region 70-4C, causing a bend in the surface of the display panel 50.

A length of the third opening pattern 71C as described herein may be less than a length of the first opening pattern 71A. For example, the length of the third opening pattern 71C may be equal to or less than 40% of the length of the first opening pattern 71A and may also exceed 0%. In this case, when the length of the third opening pattern 71C exceeds 40% of the length of the first opening pattern 71A, the support plate 70 may be distorted.

According to another embodiment, the length of the third opening pattern 71C may be less than the length of the first opening pattern 71A, and a width of the third opening pattern 71C may be less than a width of the first opening pattern 71A.

In the above case, the area of the second pattern region 70-4B may be similar to that described herein with reference to FIG. 8A. In other words, the area of the second pattern region 70-4B may be about 5% to about 40% of the sum of all of the areas of the first pattern region 70-4A, the second pattern region 70-4B, and the third pattern region 70-4C. In an example in which an amount by which the second interval WD2 between the second opening patterns 71B spaced apart from each other in the second pattern region 70-4B increases is 10 µm or less, the area of the second pattern region 70-4B may be about 5% to about 40% of the sum of all of the areas of the first pattern region 70-4A, the second pattern region 70-4B, and the third pattern region 70-4C. According to another embodiment, when the amount by which the second interval WD2 increases is 10 µm or greater, the area of the second pattern region 70-4B may be about 5% to about 20% of the sum of all of the areas of the first pattern region 70-4A, the second pattern region 70-4B, and the third pattern region 70-4C. In this case, when occupancy of the second pattern region 70-4B in the sum of all of the areas of the first pattern region 70-4A, the second pattern region 70-4B, and the third pattern region 70-4C is too large, deformation of the support plate 70 may be hindered, and, when the occupancy of the second pattern region 70-4B in the sum of the first pattern region 70-4A and the second pattern region 70-4B is too small, the surface of the support plate 70 at the outermost edge of the second pattern region 70-4B may be bent.

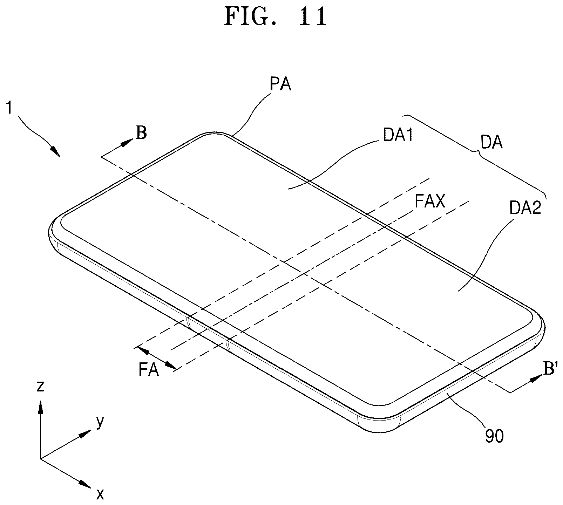

FIG. 11 is a schematic perspective view of the electronic device 1 according to another embodiment.

Referring to FIG. 11, the electronic device 1 may include the display apparatus and the lower cover 90 in which the display apparatus is accommodated. The electronic device 1 may include a display area DA, and a peripheral area PA surrounding the display area DA. According to an embodiment, the electronic device 1 may include a folding area FA, and the display area DA may include a first display area DA1 and a second display area DA2 spaced apart from each other with the folding area FA interposed between the first display area DA1 and the second display area DA2. In this case, the display area DA, the folding area FA, and the peripheral area PA are the same as or similar to those described herein with reference to FIG. 5A, and thus detailed descriptions thereof are omitted herein.

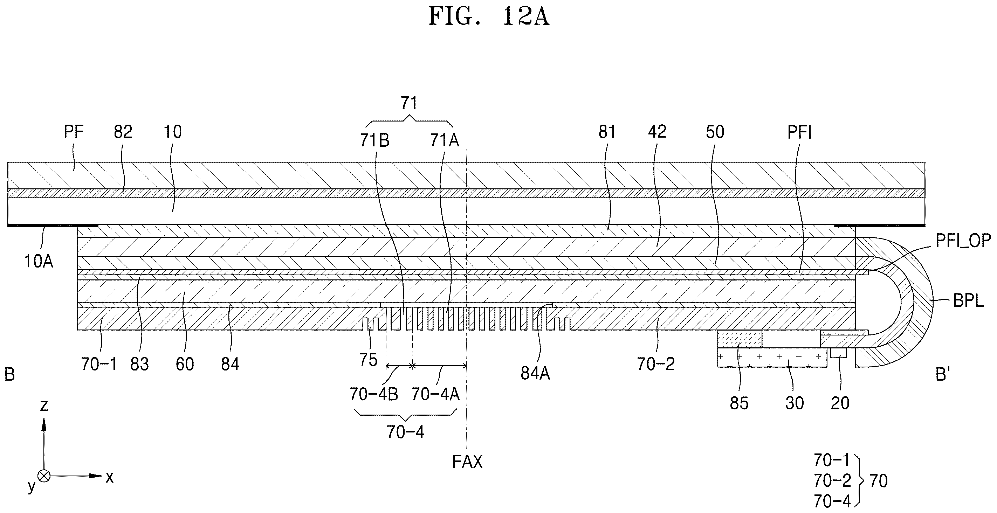

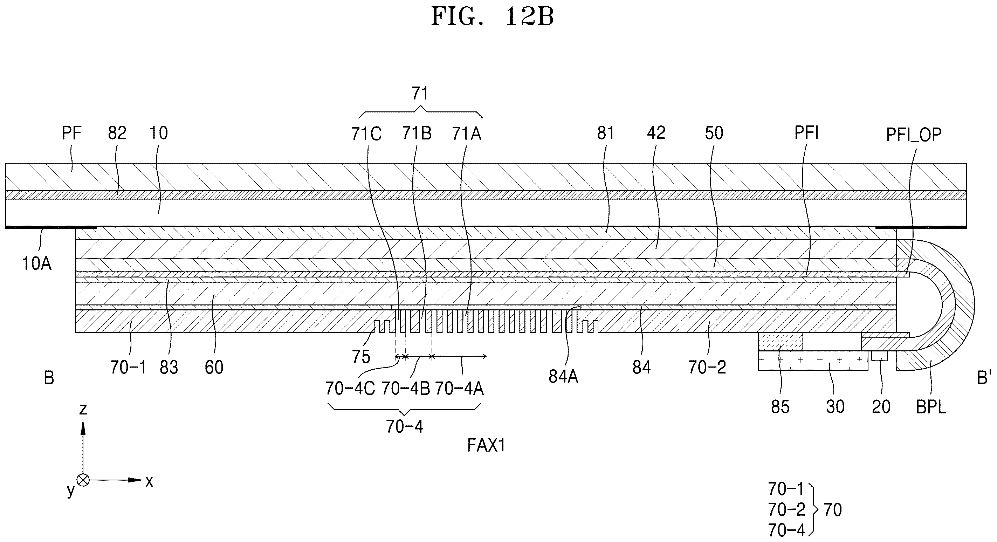

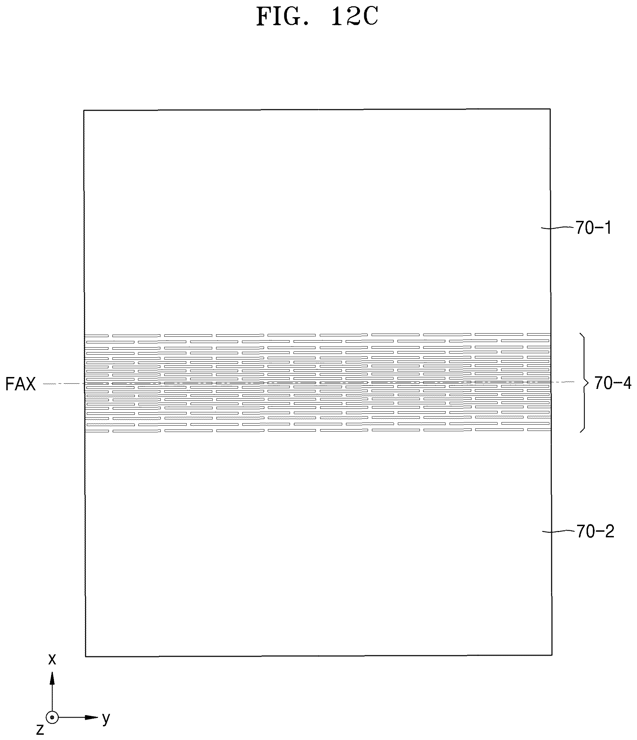

FIGS. 12A and 12B are schematic cross-sectional views of a portion of the electronic device 1 of FIG. 11. FIGS. 12A and 12B are cross-sectional views taken along line B-B' in FIG. 11. FIG. 12C is a schematic plan view of the support plate 70 of FIG. 12A or 12B.

Referring to FIGS. 12A and 12B, the display apparatus 200 (see FIG. 13) may include an anti-reflection layer PF, a cover member 10, a data driver 20, a display circuit board 30, a panel protective member PFI, a functional layer 42, a display panel 50, a reinforcing member 60, a support plate 70, a first adhesive member 81, a second adhesive member 82, a third adhesive member 83, a fourth adhesive member 84, and a fifth adhesive member 85. In this case, the anti-reflection layer PF, the cover member 10, the data driver 20, the display circuit board 30, the panel protective member PFI, the functional layer 42, the display panel 50, the reinforcing member 60, the first adhesive member 81, the second adhesive member 82, the third adhesive member 83, the fourth adhesive member 84, and the fifth adhesive member 85 are the same as or similar to those described herein with reference to FIG. 6A, so detailed descriptions thereof will be omitted.

The support plate 70 may include a first portion 70-1, a second portion 70-2, and a fourth portion 70-4. In this case, the first portion 70-1, the second portion 70-2, and the fourth portion 70-4 may be the same as or similar to those described herein with reference to FIG. 7.

Referring to FIGS. 12A, the fourth portion 70-4 may include a first pattern region 70-4A and a second pattern region 70-4B. In this case, the first pattern region 70-4A and the second pattern region 70-4B may be the same as or similar to those described herein with reference to FIGS. 8A through 8C.

Referring to FIGS. 12B, the fourth portion 70-4 may include a first pattern region 70-4A, a second pattern region 70-4B, and a third pattern region 70-4C. In this case, the first pattern region 70-4A, the second pattern region 70-4B, and the third pattern region 70-4C may be the same as or similar to those described herein with reference to FIGS. 10A through 10C.

FIG. 13 is a schematic perspective view of the electronic device 1 according to another embodiment.

Referring to FIG. 13, the electronic device 1 may include the display apparatus 200 and a housing. In this case, a portion of the housing may be deployable relative to another portion of the housing, and the display apparatus 200 may be deployed together with the portion of the housing. That is, at least a portion of the electronic device 1 may slide such that the display apparatus 200 may have an extension exposed to the outside. For example, assuming that an area of the display apparatus 200 exposed to the outside when at least a portion of the electronic device 1 is not deployed is a first area, a second area of the display apparatus 200 exposed to the outside when at least a portion of the electronic device 1 slides may exceed one time the first area. That is, when a portion of the electronic device 1 is deployed, an area in which an image is displayed on the display apparatus 200 may increase. The electronic device 1 may not only slide but also may be partially folded. For convenience of description, a case where the electronic device 1 is a notebook will now be focused on and described in detail.

The electronic device 1 may include an upper cover HS, which is the housing, and a lower cover 90. In this case, the upper cover HS and the lower cover 90 may be connected to each other through a separate hinge portion HG. The upper cover HS and the lower cover 90 may form various angles as applicable in accordance with one or more embodiments of the present disclosure. The upper cover HS may be deployable. For example, the upper cover HS may include a first upper cover HS1 and a second upper cover HS2, the first upper cover HS1 may be arranged to be slidable relative to the second upper cover HS2, and a structure for fixing a location of the first upper cover HS1 may be arranged according to the location of the first upper cover HS1. According to another embodiment, a separate driver may be arranged between the first upper cover HS1 and the second upper cover HS2, such that the first upper cover HS1 may be deployed from the second upper cover HS2 according to an operation of the driver. In this case, a structure in which the first upper cover HS1 and the second upper cover HS2 are deployed is not limited to the above, and various methods may be used.

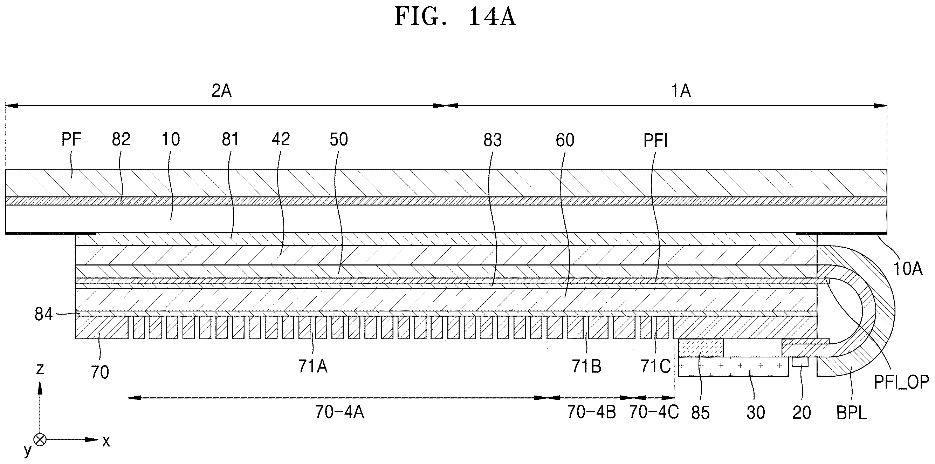

The display apparatus 200 including a display panel may be accommodated in the upper cover HS and the lower cover 90. For example, a portion of the display apparatus 200 may be accommodated in the upper cover HS, and another portion of the display apparatus 200 may be accommodated in the lower cover 90. An end of the cover member 10 (see FIG. 14A) of the display apparatus 200 may be connected to the first upper cover HS1 and may move when the first upper cover HS1 is deployed. A portion of the display panel 50 (see FIG. 14A) may be disposed inside the lower cover 90, and then be pulled out from the lower cover 90 when the first upper cover HS1 moves and moved toward the second upper cover HS2. In such a case, another portion of the display apparatus 200 may be stored flat inside the lower cover 90, or may be wound on a roller or the like.

The electronic device 1 may include the input module 6 disposed in the lower cover 90. The input module 6 may be in the form of a physical button and/or keyboard capable of inputting various characters, symbols, or the like The input module 6 may include a plurality of buttons, each of which may receive a signal from a user and display an image and/or characters on the display apparatus 200.

The electronic device 1 may further include the components described herein with reference to FIG. 1 in addition to the aforementioned components.

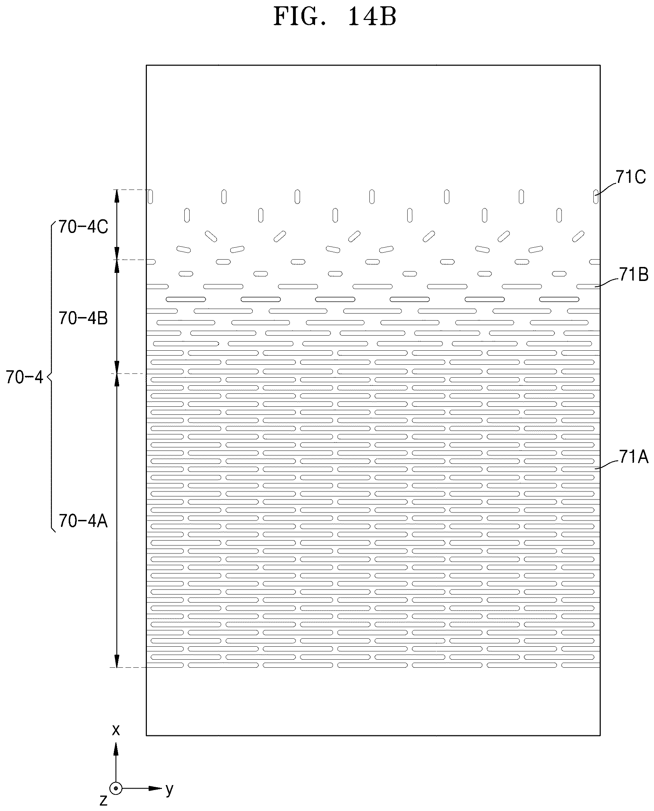

FIG. 14A is a schematic cross-sectional view of a portion of the electronic device 1 of FIG. 13. FIG. 14B is a schematic plan view of the support plate 70 illustrated in FIG. 14A.

Referring to FIGS. 14A and 14B, the display apparatus 200 of the electronic device 1 may include an anti-reflection layer PF, a cover member 10, a data driver 20, a display circuit board 30, a panel protective member PFI, a functional layer 42, a display panel 50, a reinforcing member 60, a support plate 70, a first adhesive member 81, a second adhesive member 82, a third adhesive member 83, a fourth adhesive member 84, and a fifth adhesive member 85. In this case, the anti-reflection layer PF, the cover member 10, the data driver 20, the display circuit board 30, the panel protective member PFI, the functional layer 42, the display panel 50, the reinforcing member 60, the first adhesive member 81, the second adhesive member 82, the third adhesive member 83, the fourth adhesive member 84, and the fifth adhesive member 85 are the same as or similar to those described herein with reference to FIG. 6A, so detailed descriptions thereof will be omitted.

The support plate 70 may include a first accommodation area 1A and a second accommodation area 2A. In an example in which the first upper cover HS1 is not deployed, the first accommodation area 1A is accommodated in the upper cover HS, and the second accommodation area 2A is accommodated in the lower cover 90. In this case, at least a portion of the first accommodation area 1A and at least a portion of the second accommodation area 2A may include the fourth portion 70-4, which is a variable area whose shape is variable. Expressed another way, the fourth portion 70-4 has a varied shape.

The fourth portion 70-4 may include a first pattern region 70-4A, a second pattern region 70-4B, and a third pattern region 70-4C. In this case, the first pattern region 70-4A, the second pattern region 70-4B, and the third pattern region 70-4C may be the same as or similar to those described herein with reference to FIGS. 10A through 10C. In some embodiments, the first pattern region 70-4A may be disposed inside the lower cover 90, and at least a portion of the first pattern region 70-4A may move inside the lower cover 90 when the display apparatus 200 slides.

In such a case, one of each of the first pattern region 70-4A, the second pattern region 70-4B, and the third pattern region 70-4C of the fourth portion 70-4 may be arranged. For example, only one of each of the first pattern region 70-4A, the second pattern region 70-4B, and the third pattern region 70-4C of the fourth portion 70-4 may be arranged. The first pattern region 70-4A, the second pattern region 70-4B, and the third pattern region 70-4C may be arranged in a single direction of the support plate 70. For example, the first pattern region 70-4A, the second pattern region 70-4B, and the third pattern region 70-4C may be sequentially arranged in a direction from a lower side of the support plate 70 to an upper side of the support plate 70 as illustrated in FIG. 14B. The second pattern region 70-4B and the third pattern region 70-4C may be arranged on a single side of the first pattern region 70-4A. Accordingly, even when a portion of the display panel 50 that is deformed varies when the display panel 50 is bent or slides, the first pattern region 70-4A may effectively support the display panel 50 and also accommodate the deformation. In some aspects, the second pattern region 70-4B and the third pattern region 70-4C may reduce occurrence of a curvature on the surface of the display panel 50 by reducing a surface curvature of the support plate 70 at a boundary of the fourth portion 70-4 of the support plate 70.

When the display panel 50 slides, at least a portion of the fourth portion 70-4 may be disposed to overlap the hinge portion HG. At this time, a region of the fourth portion 70-4 that overlaps the hinge portion HG may vary as the display panel 50 is pulled out of the lower cover 90. For example, the first pattern region 70-4A may be disposed to overlap the hinge portion HG, and, when the display panel 50 is pulled out from the lower cover 90, a portion of the first pattern region 70-4A overlapping the hinge portion HG may continuously vary. A portion of the display panel 50 and a portion of the support plate 70 may be bent from another portion of the display panel 50 and another portion of the support plate 70, and the portion of the display panel 50 and the portion of the support plate 70 that are bent may vary as the display panel 50 is pulled out of the lower cover 90. The fourth portion 70-4 may smoothly deform the support plate 70 by arranging the first opening pattern 71A, the second opening pattern 71B, and the third opening pattern 71C in various portions. In this case, the first opening pattern 71A, the second opening pattern 71B, and the third opening pattern 71C may include a width in the second direction (e.g., the x-axis direction of FIG. 14B) that is the same as the second direction in which the display apparatus 200 slides, and a length in a first direction (e.g., the y-axis direction of FIG. 14B) that is perpendicular to the second direction.

An interval between second opening patterns 71B adjacent to each other in the second direction (for example, the x-axis direction in FIG. 14B) may increase from the lower side of the support plate 70 to the upper side of the support plate 70, based on FIG. 14B. In some aspects, an angle formed by the lengthwise direction of the third opening pattern 71C and the second direction may decrease from the lower side of the support plate 70 to the upper side of the support plate 70, based on FIG. 14B. In particular, the lengthwise direction of the third opening pattern 71C arranged at the outermost edge of the fourth portion 70-4 may be parallel to the second direction.

In the above case, when a portion of the display apparatus 200 is withdrawn from the lower cover 90 or inserted into the lower cover 90, a force may be applied to the support plate 70. At this time, a sudden change in stress may occur at a boundary portion of the fourth portion 70-4 disposed in the upper cover HS due to the force applied to the support plate 70. In such a case, the boundary portion of the fourth portion 70-4 disposed in the upper cover HS may be curved. The curvature of the support plate 70 may also cause curvature also on the surface of the display panel 50. In particular, when the fourth portion 70-4 includes only the first pattern region 70-4A in which first opening patterns 71A are arranged, a single plane may not be formed on the surface of the support plate 70 at the boundary portion of the first pattern region 70-4A, and an inflection point in which the radius of curvature changes abruptly or straight lines of a cross-section have different slopes may occur on the support plate 70. Due to the inflection point of the surface of the support plate 70, surfaces of the reinforcing member 60, the display panel 50, the cover member 10, and the like on the support plate 70 may also have similar inflection points to the inflection point of the surface of the support plate 70. At this time, an inflection point may be disposed on the upper cover HS and is visible to a user through the portion of the display apparatus 200 exposed to the outside, such that the display apparatus 200 may display a distorted image when the display apparatus 200 operates.

However, as described herein, the second pattern region 70-4B in which second opening patterns 71B are arranged and the third pattern region 70-4C in which third opening patterns 71C are arranged may not only sequentially vary a stress change according to the force applied to the support plate 70, but also may disperse the stress in various directions. Accordingly, the second pattern region 70-4B and the third pattern region 70-4C may gently help a change in the shape of the support plate 70 at the boundary of the first pattern region 70-4A arranged in the upper cover HS.

Therefore, the second opening pattern 71B and the third opening pattern 71C may reduce the curvature of the surface of the display panel 50 by reducing the curvature of the support plate 70 at the outermost edge of the first pattern region 70-4A.

In the above case, respective areas of the second pattern region 70-4B and the third pattern region 70-4C arranged on the plane of the support plate 70 may be the same as those described herein with reference to FIGS. 10A through 10C. In some aspects, respective centers of the first opening patterns 71A and the second opening patterns 71B may be arranged on the same straight line as illustrated in FIG. 8A or FIG. 8B. In some aspects, a third opening pattern 71C disposed at an outermost side among the third opening patterns 71C (for example, a third opening pattern 71C disposed at an uppermost side based on FIG. 14B) may be disposed on a straight line where the centers of the first opening pattern 71A and the second opening pattern 71B are arranged.

Although not illustrated in the drawings, the support plate 70 may not include the third pattern region 70-4C, but may include the first pattern region 70-4A and the second pattern region 70-4B. In this case, the first pattern region 70-4A and the second pattern region 70-4B may be the same as or similar to those described herein with reference to one of FIGS. 8A through 8C. In this case, the first pattern region 70-4A and the second pattern region 70-4B may be arranged only in one direction. That is, the first pattern region 70-4A and the second pattern region 70-4B may be arranged on the support plate 70, similar to an arrangement illustrated in FIG. 14B. In this case, respective areas of the first pattern region 70-4A and the second pattern region 70-4B in a plan view may be the same as or similar to those described herein with reference to one of FIGS. 8A through 8C. In such a case, the second pattern region 70-4B may not only effectively disperse a force applied to the support plate 70 when a force is applied from one side of the display apparatus 200, but also distribute stress formed on the support plate 70 such that the stress is sequentially varied (i.e., allow stress formed on the support plate 70 to vary sequentially). This may prevent the profile of the surface of the support plate 70 from changing abruptly at the outermost edge of the second pattern region 70-4B.

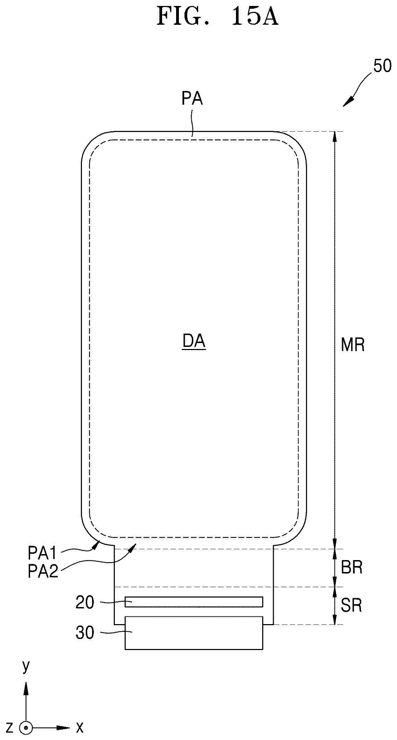

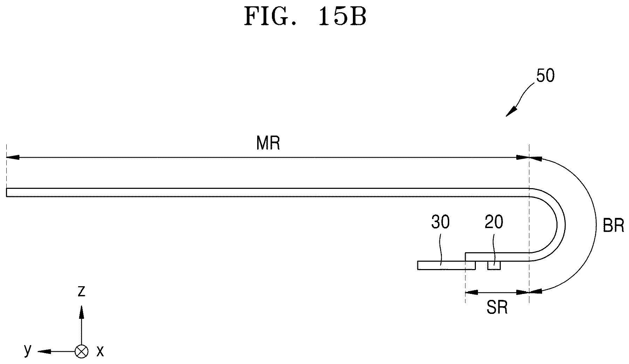

FIG. 15A is a schematic plan view of the display panel 50 and the display circuit board 30 of the electronic device 1 illustrated in FIG. 2, FIG. 3, FIG. 4, FIG. 5A, FIG. 11, or FIG. 13. FIG. 15B is a schematic side view of the display panel 50 and the display circuit board 30 illustrated in FIG. 15A. The electronic device 1 described herein may include the display panel 50 as illustrated in FIGS. 15A and 15B.

Referring to FIGS. 15A and 15B, the display panel 50 may include the display area DA, and the peripheral area PA outside the display area DA. The display area DA, in which an image is displayed, may include a plurality of subpixels arranged therein. The display area DA may have any one of various shapes such as a circular shape, an oval shape, a polygonal shape, and a particular figure shape. FIG. 15A illustrates that the display area DA has a substantially rectangular shape with rounded corners.

The peripheral area PA may be located outside the display area DA. The peripheral area PA may include a first peripheral area PA1 disposed to surround at least a portion of the display area DA, and a second peripheral area PA2 located on a lower end of the display area DA and extending in the second direction (e.g., an x-axis direction). A width of the second peripheral area PA2 in the second direction (e.g., the x-axis direction) may be less than a width of the display area DA in the second direction. This structure may facilitate bending of at least a portion of the second peripheral area PA2.

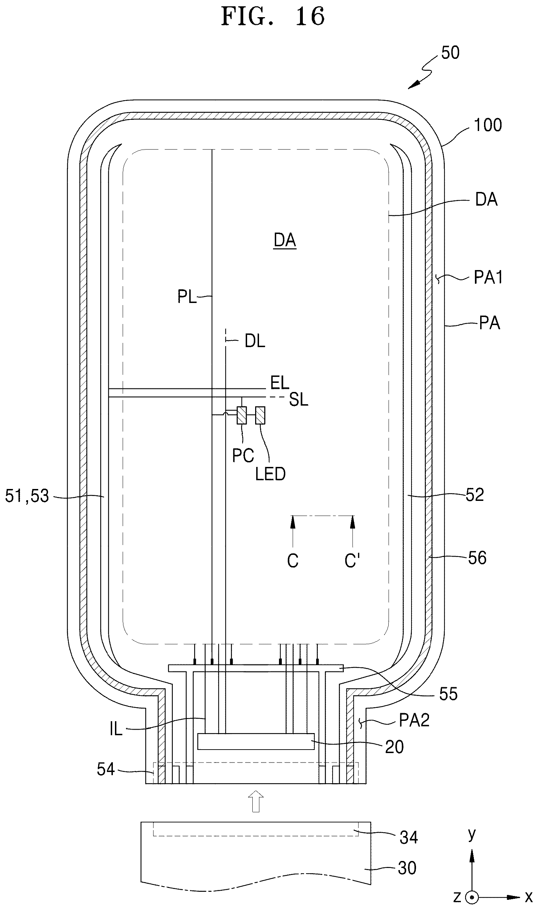

A planar shape of the display panel 50 of FIG. 15A may be substantially the same as a planar shape of the substrate 100 (see FIG. 16) included in the display panel 50. That the display panel 50 includes the display area DA and the peripheral area PA outside the display area DA may indicate that the substrate 100 includes the display area DA and the peripheral area PA outside the display area DA. For convenience of explanation, the substrate 100 will now be described as having the display area DA and the peripheral area PA.

The display panel 50 may include a main region MR, a bending region BR outside the main region MR, and a subregion SR spaced apart from the main region MR with the bending region BR interposed between the subregion SR and the main region MR. The main region MR may be disposed on one side of the bending region BR, and the subregion SR may be disposed on another side of the bending region BR. As illustrated in FIG. 15B, the display panel 50 may be bent in the bending region BR, and at least a portion of the subregion SR may overlap the main region MR when viewed in a third direction (e.g., a z-axis direction). Although FIG. 15B illustrates that the display panel 50 is bent, the disclosure is not limited thereto. For example, the display panel 50 may be a foldable display panel. In this case, the display panel 50 may be bent within the display area DA about a bending axis extending across the display area DA. As needed, the display panel 50 may not be bent. The subregion SR may be a non-display region.

A data driver 20 may be arranged in the subregion SR of the display panel 50. The data driver 20 may be disposed on the display panel 50 in the form of an integrated circuit (IC). For example, the data driver 20 may be a data driving IC that generates a data signal.

The display circuit board 30 may be attached to an end of the subregion SR of the display panel 50. The display circuit board 30 may be electrically connected to the data driver 20 via a pad in the subregion SR of the display panel 50.

FIG. 16 is a schematic plan view of the display panel 50 and the display circuit board 30 illustrated in FIG. 15A.

Referring to FIG. 16, the display panel 50 may include the substrate 100. Components that constitute the display panel 50 may be arranged on the substrate 100.

The substrate 100 may include glass, ceramic, a metal, or a polymer resin. For example, the substrate 100 may include polymer resin such as polyethersulphone, polyacrylate, polyetherimide, polyethylene naphthalate, polyethylene terephthalate, polyphenylene sulfide, polyarylate, polyimide, polycarbonate, or cellulose acetate propionate. The substrate 100 may have a multi-layered structure including two layers each including the aforementioned polymer resin and an inorganic material layer interposed between the two layers. Alternatively, the substrate 100 may have a structure in which a layer including such a polymer resin and an inorganic layer are alternately stacked. The inorganic layer may include, for example, silicon oxide, silicon nitride, or silicon oxynitride.

Subpixels may be arranged in the display area DA, and the display area DA may provide an image by using light emitted in the subpixels. Each of the subpixels may include a light-emitting diode LED, and the light-emitting diode LED may be electrically connected to a subpixel circuit PC. The subpixel circuit PC and the light-emitting diode LED may be arranged in the display area DA. In FIG. 16, for convenience, the subpixel circuit PC and the light-emitting diode LED are depicted as being positioned side by side. However, in reality, the subpixel circuit PC and the light-emitting diode LED may at least partially overlap each other. For example, the light-emitting diode LED may be disposed on the subpixel circuit PC.

A gate driving circuit, a pad 54, a first power supply line 55, and a second power supply line 56 may be arranged in the peripheral area PA. The gate driving circuit may include, for example, a first scan driving circuit 51, a second scan driving circuit 52, and/or a light-emission control driving circuit 53.

The first scan driving circuit 51 may provide a scan signal to the subpixel circuit PC via a scan line SL. The second scan driving circuit 52 may be disposed on an opposite side of the display area DA from the first scan driving circuit 51. Some of the subpixel circuits PC arranged in the display area DA may be electrically connected to the first scan driving circuit 51, and the remaining ones of the subpixel circuits PC may be connected to the second scan driving circuit 52. In some cases, the second scan driving circuit 52 may not be included.

The light-emission control driving circuit 53 may be disposed on one side of the display area DA, similar to the first scan driving circuit 51. The light-emission control driving circuit 53 may provide a light-emission control signal to each subpixel P (see FIG. 5A) via a light-emission control line EL. Although it is illustrated in FIGS. 5A and 5B that light-emission control driving circuits 53 are arranged on both sides of the display area DA, the disclosure is not limited thereto. For example, the display panel 50 may include a light-emission control driving circuit 53 arranged on a single side of the display area DA. Alternatively, the first scan driving circuit 51 may be disposed on one side of the display area DA, and the light-emission control driving circuit 53 may be disposed on the other side thereof.

The pad 54 may be disposed in the second peripheral area PA2 of the substrate 100. The pad 54 may be exposed without being covered by an insulating layer, and may be electrically connected to the display circuit board 30. A pad 34 of the display circuit board 30 may be electrically connected to the pad 54 of the display panel 50.

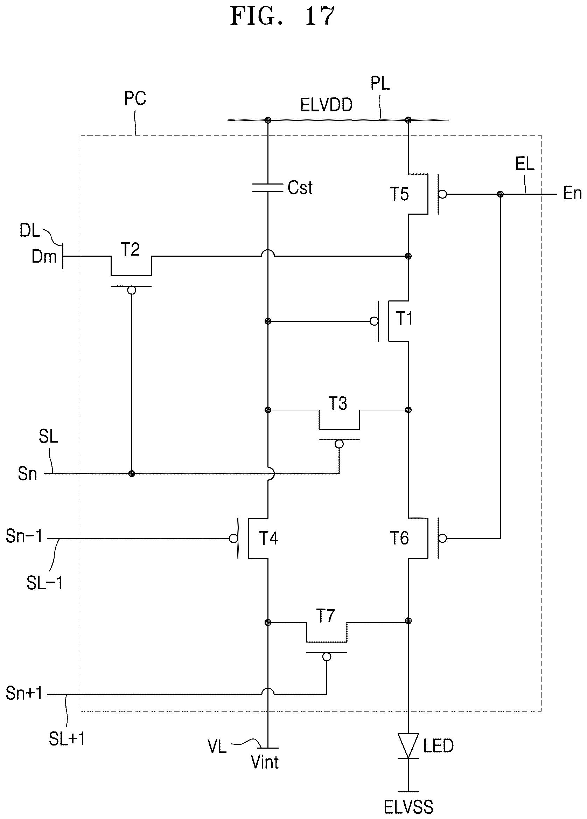

The display circuit board 30 transmits a signal or power of a controller to the display panel 50. A control signal generated by the controller may be transmitted to the gate driving circuit via the display circuit board 30. The controller may provide a first power supply voltage ELVDD (see FIG. 17) and a second power supply voltage ELVSS (see FIG. 17) to the first power supply line 55 and the second power supply line 56 respectively. The first power supply voltage (hereinafter, referred to as a driving voltage) ELVDD may be provided to each of the subpixel circuits PC via a driving voltage line PL connected to the first power supply line 55, and the second power supply voltage (hereinafter, referred to as a common voltage) ELVSS may be provided to a common electrode of the light-emitting diode LED connected to the second power supply line 56. The first power supply line 55 may extend in the second direction (e.g., the x-axis direction). The second power supply line 56 may partially surround the display area DA by having a loop shape of which one side is open.

A data signal of the data driver 20 may be transmitted to a subpixel circuit PC via an input line IL and a data line DL electrically connected to the input line IL.

FIG. 17 is an equivalent circuit diagram of one subpixel arranged in the display area DA of the display panel 50 of FIG. 16.

Referring to FIG. 17, a light-emitting diode LED may be electrically connected to a subpixel circuit PC.

The subpixel circuit PC may include a first thin-film transistor T1, a second thin-film transistor T2, a third thin-film transistor T3, a fourth thin-film transistor T4, a fifth thin-film transistor T5, a sixth thin-film transistor T6, a seventh thin-film transistor T7, and a storage capacitor Cst.

The second thin-film transistor T2, which is a switching thin-film transistor, may be connected to a scan line SL and a data line DL, and transmit, to the first thin-film transistor T1, a data voltage (or a data signal Dm) received via the data line DL, based on a switching voltage (or a switching signal Sn) received via the scan line SL. The storage capacitor Cst may be connected to the first thin-film transistor T1 and the driving voltage line PL, and may store a voltage corresponding to a difference between a voltage received from the second thin-film transistor T2 and the first power supply voltage ELVDD supplied to the driving voltage line PL.

The first thin-film transistor T1, which is a driving thin-film transistor, may be connected to the driving voltage line PL and the storage capacitor Cst, and may control a driving current flowing from the driving voltage line PL to the light-emitting diode LED, in accordance with a voltage value stored in the storage capacitor Cst. The light-emitting diode LED may emit light having a predetermined brightness due to the driving current. A second electrode (for example, a cathode) of the light-emitting diode LED may receive the second power supply voltage ELVSS.

The third thin-film transistor T3 is a compensation thin-film transistor, and a gate electrode of the third thin-film transistor T3 may be connected to the scan line SL. A source electrode (or a drain electrode) of the third thin-film transistor T3 may be connected to a drain electrode (or a source electrode) of the first thin-film transistor T1 and may also be connected to a first electrode of the light-emitting diode LED via the sixth thin-film transistor T6. A drain electrode (or a source electrode) of the third thin-film transistor T3 may be connected to one electrode of the storage capacitor Cst, a source electrode (or a drain electrode) of the fourth thin-film transistor T4, and a gate electrode of the first thin-film transistor T1. The third thin film transistor T3 is turned on according to the scan signal Sn received via the scan line SL and connects the gate electrode and the drain electrode of the first thin-film transistor T1 to each other, thus achieving diode-connection of the first thin film transistor T1.

A gate electrode of the fourth thin-film transistor T4, which is an initialization thin-film transistor, may be connected to a previous scan line SL-1. A drain electrode (or a source electrode) of the fourth thin-film transistor T4 may be connected to an initializing voltage line VL. A source electrode (or a drain electrode) of the fourth thin-film transistor T4 may be connected to the one electrode of the storage capacitor Cst, the drain electrode (or the source electrode) of the third thin film transistor T3, and the gate electrode of the first thin-film transistor T1. The fourth thin-film transistor T4 may be turned on according to a previous scan signal Sn-1 received via the previous scan line SL-1 and may transmit an initializing voltage Vint to the gate electrode of the first thin-film transistor T1 to thereby initialize a voltage of the gate electrode of the first thin-film transistor T1.

A gate electrode of the fifth thin-film transistor T5, which is an operation control thin-film transistor, may be connected to the light-emission control line EL. A source electrode (or a drain electrode) of the fifth thin-film transistor T5 may be connected to the driving voltage line PL. The drain electrode (or the source electrode) of the fifth thin-film transistor T5 is connected to the source electrode (or the drain electrode) of the first thin-film transistor T1 and the drain electrode (or the source electrode) of the second thin-film transistor T2.

A gate electrode of the sixth thin-film transistor T6, which is a light-emission control thin-film transistor, may be connected to the light-emission control line EL. A source electrode (or a drain electrode) of the sixth thin-film transistor T6 may be connected to the drain electrode (or the source electrode) of the first thin-film transistor T1 and the source electrode (or the drain electrode) of the third thin-film transistor T3. The drain electrode (or the source electrode) of the sixth thin-film transistor T6 may be electrically connected to the first electrode of the light-emitting diode LED. The fifth thin-film transistor T5 and the sixth thin-film transistor T6 are simultaneously turned on according to a light-emission control signal En received via the light-emission control line EL, and thus the driving voltage ELVDD is transmitted to the light-emitting diode LED and a driving current flows in the light-emitting diode LED.

The seventh thin-film transistor T7 may be an initialization thin-film transistor that initializes the first electrode of the light-emitting diode LED. A gate electrode of the seventh thin-film transistor T7 may be connected to a next scan line SL+1. A source electrode (or a drain electrode) of the seventh thin-film transistor T7 may be connected to the first electrode of the light-emitting diode LED. The drain electrode (or the source electrode) of the seventh thin-film transistor T7 may be connected to the initializing voltage line VL. The seventh thin-film transistor T7 may be turned on according to a next scan signal Sn+1 received via the next scan line SL+1 and may initialize the first electrode of the light-emitting diode LED.

In FIG. 17, the fourth thin-film transistor T4 and the seventh thin-film transistor T7 are connected to the previous scan line SL-1 and the next scan line SL+1, respectively. However, according to another embodiment, the fourth thin-film transistor T4 and the seventh thin-film transistor T7 may be both connected to the previous scan line SL-1 to operate according to the previous scan signal Sn-1.

Another electrode of the storage capacitor Cst may be connected to the driving voltage line PL. The one electrode of the storage capacitor Cst may be connected to the gate electrode of the first thin-film transistor T1, the drain electrode (or the source electrode) of the third thin-film transistor T3, and the source electrode (or the drain electrode) of the fourth thin-film transistor T4.

The second electrode (for example, the cathode) of the light-emitting diode LED receives the second power supply voltage ELVSS. The light-emitting diode LED receives the driving current from the first thin-film transistor T1 and emits light.

The light-emitting diode LED may be an organic light-emitting diode containing an organic material as a light-emitting material. According to another embodiment, the light-emitting diode LED may be an inorganic light-emitting diode including an inorganic material. The inorganic light-emitting diode may include a PN diode including materials based on an inorganic material semiconductor. When a voltage is applied to the PN diode in a forward direction, holes and electrons are injected, and energy generated by recombination of the holes and the electrons is converted into light energy to thereby emit light of a predetermined color. The above-mentioned inorganic light-emitting diode may have a width of several to several hundreds of micrometers or several to several hundreds of nanometers. According to some embodiments, the light-emitting diode LED may include a quantum dot light-emitting diode. As described herein, an emission layer of the light-emitting diode LED may include an organic material, include an inorganic material, include quantum dots, include an organic material and quantum dots, or include an inorganic material and quantum dots. For convenience of explanation, a case where the light-emitting diode LED includes an organic light-emitting diode will now be described.

In FIG. 17, the subpixel circuit PC includes seven transistors and one capacitor. However, according to another embodiment, the subpixel circuit PC may include three or more transistors, and may include three or more capacitors. In some aspects, a circuit design of the subpixel circuit PC is not limited to that illustrated in FIG. 17, and may vary.

The first, second, third, fourth, fifth, sixth, and seventh thin-film transistors T1, T2, T3, T4, T5, T6, and T7 may be all various types of transistors. According to an embodiment, the first, second, third, fourth, fifth, sixth, and seventh thin-film transistors T1, T2, T3, T4, T5, T6, and T7 may be all p-channel MOSFETs (PMOS transistors). According to another embodiment, at least one of the first, second, third, fourth, fifth, sixth, and seventh thin-film transistors T1, T2, T3, T4, T5, T6, and T7 may be p-channel MOSFETs (PMOS transistors), and the others may be n-channel MOSFETs (NMOS transistors). According to another embodiment, the first, second, third, fourth, fifth, sixth, and seventh thin-film transistors T1, T2, T3, T4, T5, T6, and T7 may be all n-channel MOSFETs (NMOS transistors). Locations of sources and drains may be interchanged depending on the type (p-type or n-type) of transistors.

The first, second, third, fourth, fifth, sixth, and seventh thin-film transistors T1, T2, T3, T4, T5, T6, and T7 illustrated in FIG. 17 may be all transistors having low-temperature polysilicon semiconductors. In this case, the first, second, third, fourth, fifth, sixth, and seventh thin-film transistors T1, T2, T3, T4, T5, T6, and T7 are not limited to the above, and at least one of the first, second, third, fourth, fifth, sixth, and seventh thin-film transistors T1, T2, T3, T4, T5, T6, and T7 may be a transistor having a low-temperature polycrystalline silicon (LTPS) semiconductor layer, and the rest may be transistors having oxide semiconductor layers. Alternatively, the first, second, third, fourth, fifth, sixth, and seventh thin-film transistors T1, T2, T3, T4, T5, T6, and T7 may be all transistors having oxide semiconductor layers.

FIG. 18 is a schematic cross-sectional view of a portion of the display area DA of the display panel 50 of FIG. 16. FIG. 18 is a cross-sectional view taken along line C-C' in FIG. 16.

Referring to FIG. 18, a subpixel circuit PC and a light-emitting diode, for example, an organic light-emitting diode OLED, arranged in the display area DA of the display panel 50 are illustrated.

The substrate 100 may include glass, ceramic, a metal, or a polymer resin. According to an embodiment, the substrate 100 may have a structure in which a base layer including polymer resin and a barrier layer including an inorganic insulating material such as silicon oxide or silicon nitride are alternately stacked. In an example in which the substrate 100 includes a stack structure of a base layer of a polymer resin and a barrier layer of an inorganic insulating material, flexibility of the electronic device 1 is improved, such that a foldable electronic device 1 may be provided.

The inorganic insulating material may include silicon oxide, silicon nitride, and/or silicon oxynitride.

Examples of the polymer resin may include polyethersulfone, polyacrylate, polyetherimide, polyethylene naphthalate, polyethylene terephthalate, polyphenylene sulfide, polyarylate, polyimide, polycarbonate, and cellulose acetate propionate. For convenience of description, a case where the substrate 100 is formed of glass will now be described in detail.

The subpixel circuit PC may be formed on the substrate 100, and the light-emitting diode, for example, the organic light-emitting diode OLED, may be formed on the subpixel circuit PC.

A buffer layer 201 for preventing infiltration of impurities into the subpixel circuit PC may be formed on the substrate 100 before the subpixel circuit PC is formed on the substrate 100. The buffer layer 201 may include an inorganic insulating material, such as silicon nitride, silicon oxynitride, and/or silicon oxide, and may be a single layer or multiple layers including the inorganic insulating material.

The subpixel circuit PC may include a plurality of transistors and a storage capacitor as described herein with reference to FIG. 17. In this regard, FIG. 18 illustrates a first thin-film transistor T1, a third thin-film transistor T3, and a storage capacitor Cst.

The first thin-film transistor T1 may include a semiconductor layer on the buffer layer 201 (hereinafter, referred to as a first semiconductor layer A1) and a gate electrode overlapping a channel region C1 of the first semiconductor layer A1 (hereinafter, referred to as a first gate electrode GE1). The first semiconductor layer A1 may include a silicon-based semiconductor material, for example, polysilicon. The first semiconductor layer A1 may include the channel region C1 and a first region B1 and a second region D1 respectively arranged on both sides of the channel region C1. The first region B1 and the second region D1 are regions containing higher concentrations of impurities than the channel region C1, and one of the first region B1 and the second region D1 may correspond to a source region and the other may correspond to a drain region.

A first gate insulating layer 203 may be disposed between the first semiconductor layer A1 and the first gate electrode GE1. The first gate insulating layer 203 may include an inorganic insulating material, such as silicon oxide, silicon nitride, or silicon oxynitride, and may be a single layer or multiple layers including the inorganic insulating material.

The first gate electrode GE1 may include a conductive material including molybdenum (Mo), aluminum (Al), copper (Cu), titanium (Ti), or the like, and may have a single-layer or multi-layer structure including the aforementioned materials.

The storage capacitor Cst may include a lower electrode CE1 and an upper electrode CE2 overlapping each other. According to an embodiment, the lower electrode CE1 of the storage capacitor Cst may include the first gate electrode GE1. In other words, the first gate electrode GE1 may include the lower electrode CE1 of the storage capacitor Cst. For example, the first gate electrode GE1 may be integrally formed with the lower electrode CE1 of the storage capacitor Cst.

A first interlayer insulating layer 205 may be disposed between the lower electrode CE1 and the upper electrode CE2 of the storage capacitor Cst. The first interlayer insulating layer 205 may include an inorganic insulating material, such as silicon oxide, silicon nitride, or silicon oxynitride, and may be a single layer or multiple layers including the inorganic insulating material.

The upper electrode CE2 of the storage capacitor Cst may include a low-resistance conductive material such as molybdenum (Mo), aluminum (Al), copper (Cu), and/or titanium (Ti), and may have a multi-layer or single layer structure including the aforementioned materials.

A second interlayer insulating layer 207 may be disposed on the storage capacitor Cst. The second interlayer insulating layer 207 may include an inorganic insulating material, such as silicon oxide, silicon nitride, or silicon oxynitride, and may be a single layer or multiple layers including the inorganic insulating material.

A semiconductor layer of the third thin-film transistor T3 (hereinafter, referred to as a third semiconductor layer A3) may be arranged on the second interlayer insulating layer 207. The third semiconductor layer A3 may include a silicon-based semiconductor material, for example, polysilicon.

The third semiconductor layer A3 may include a channel region C3 and a first region B3 and a second region D3 respectively arranged on both sides of the channel region C3. One of the first region B3 and the second region D3 may correspond to a source region, and the other may correspond to a drain region.

The third thin-film transistor T3 may include a gate electrode overlapping the channel region C3 of the third semiconductor layer A3 (hereinafter, referred to as a third gate electrode GE3). The third gate electrode GE3 may have a dual gate structure including a lower gate electrode G3A disposed below the third semiconductor layer A3 and an upper gate electrode G3B disposed above the channel region C3.

The lower gate electrode G3A may be disposed on a layer (e.g., the first interlayer insulating layer 205) that is the same as a layer on which the upper electrode CE2 of the storage capacitor Cst is disposed. The lower gate electrode G3A may include a material that is the same as a material included in the upper electrode CE2 of the storage capacitor Cst.

The upper gate electrode G3B may be disposed on the third semiconductor layer A3 with the second gate insulating layer 209 between the upper gate electrode G3B and the third semiconductor layer A3. The second gate insulating layer 209 may include an inorganic insulating material, such as silicon oxide, silicon nitride, or silicon oxynitride, and may be a single layer or multiple layers including the inorganic insulating material.

A third interlayer insulating layer 210 may be disposed on the upper gate electrode G3B. The third interlayer insulating layer 210 may include an inorganic insulating material, such as silicon oxynitride, and may be a single layer or multiple layers including the inorganic insulating material.

FIG. 18 illustrates the first thin-film transistor T1 and the third thin-film transistor T3 among a plurality of thin-film transistors as described herein with reference to FIG. 17, and illustrates that the first semiconductor layer A1 and the third semiconductor layer A3 are arranged on different layers. However, the disclosure is not limited thereto.

The second, fourth, fifth, sixth, and seventh thin-film transistors T2, T4, T5, T6, and T7 of FIG. 17 described herein with reference to FIG. 17 may have the same structure as the first thin-film transistor T1 described herein with reference to FIG. 18. For example, the second, fourth, fifth, sixth, and seventh thin-film transistors T2, T4, T5, T6, and T7 of FIG. 17 may include semiconductor layers disposed on the same layer on which the first semiconductor layer A1 of the first thin-film transistor T1 is disposed, and gate electrodes disposed on the same layer on which the first gate electrode GE1 of the first thin-film transistor T1 is disposed. The semiconductor layers of the second, fourth, fifth, sixth, and seventh thin-film transistors T2, T4, T5, T6, and T7 of FIG. 17 may be integrally connected with the first semiconductor layer A1.

The first thin-film transistor T1 and the third thin-film transistor T3 may be electrically connected to each other through a node connection line 166. The node connection line 166 may be disposed on the third interlayer insulating layer 210. One side of the node connection line 166 may be connected to the first gate electrode GE1 of the first thin-film transistor T1, and the other side of the node connection line 166 may be connected to the third semiconductor layer A3 of the third thin-film transistor T3.

The node connection line 166 may include Al, Cu, and/or Ti, and may be a multi-layer or single layer including the aforementioned materials. For example, the node connection line 166 may have a three-layered structure of Ti layer/Al layer/Ti layer.

A first organic insulating layer 211 may be disposed on the node connection line 166. The first organic insulating layer 211 may include an organic insulating material. The organic insulating material may include acryl, benzocyclobutene (BCB), polyimide, or hexamethyldisiloxane (HMDSO).

The data line DL and the driving voltage line PL may be arranged on the first organic insulating layer 211 and be covered with the second organic insulating layer 213. The data line DL and the driving voltage line PL may include Al, Cu, and/or Ti, and may be a multi-layer or single layer including the aforementioned materials. For example, the data line DL and the driving voltage line PL may have a three-layered structure of Ti layer/Al layer/Ti layer.

The second organic insulating layer 213 may include an organic insulating material, such as acryl, benzocyclobutene (BCB), polyimide, or hexamethyldisiloxane (HMDSO). Although FIG. 18 illustrates that the data line DL and the driving voltage line PL are formed on the first organic insulating layer 211, the disclosure is not limited thereto. According to another embodiment, either the data line DL or the driving voltage line PL may be disposed on a layer, for example, on the third interlayer insulating layer 210, that is the same as a layer on which the node connection line 166 is disposed.

The light-emitting diode, for example, the organic light-emitting diode OLED, may be disposed on the second organic insulating layer 213.

A first electrode 221 of the organic light-emitting diode OLED may include a reflective layer including silver (Ag), magnesium (Mg), aluminum (Al), platinum (Pt), palladium (Pd), gold (Au), nickel (Ni), neodymium (Nd), iridium (Ir), chromium (Cr), and/or a compound of these materials. According to another embodiment, the first electrode 221 may further include a conductive oxide layer above and/or below the reflective layer. The conductive oxide layer may include indium tin oxide (ITO), indium zinc oxide (IZO), zinc oxide (ZnO), indium oxide (In₂O₃), indium gallium oxide (IGO), and/or aluminum zinc oxide (AZO). According to an embodiment, the first electrode 221 may have a three-layered structure of ITO/Ag/ITO layers.

A bank layer 215 may be disposed on the first electrode 221. The bank layer 215 may include an opening that overlaps the first electrode 221, and may cover an edge of the first electrode 221. The bank layer 215 may include an organic insulating material such as polyimide.

An intermediate layer 222 includes an emission layer 222b. The intermediate layer 222 may include a first functional layer 222a below the emission layer 222b, and/or a second functional layer 222c above the emission layer 222b. The emission layer 222b may include a low molecular weight or high molecular weight organic material that emits light of a certain color. The second functional layer 222c may include an electron transport layer (ETL) and/or an electron injection layer (EIL). The first functional layer 222a and the second functional layer 222c may include an organic material.

The second electrode 223 may include a conductive material having a low work function. For example, the second electrode 223 may include a (semi)transparent layer including, for example, silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), and/or an alloy of these materials. Alternatively, the second electrode 223 may further include a layer, such as ITO, IZO, ZnO, and/or In₂O₃, on the (semi)transparent layer including any of the above-described materials.

The emission layer 222b may be formed in the display area DA to overlap the first electrode 221 via the opening of the bank layer 215. The first functional layer 222a, the second functional layer 222c, and the second electrode 223 may entirely cover the display area DA.

A spacer 217 may be formed on the bank layer 215. The spacer 217 may be formed together with the bank layer 215 in the same process, or may be formed individually in separate processes. According to an embodiment, the spacer 217 may include an organic insulating material such as polyimide. Alternatively, the bank layer 215 may include an organic insulating material including a light-blocking dye, and the spacer 217 may include an organic insulating material such as polyimide.

The organic light-emitting diode OLED may be covered by an encapsulation layer 300. The encapsulation layer 300 may include at least one inorganic encapsulation layer and at least one organic encapsulation layer. According to an embodiment, FIG. 18 illustrates that the encapsulation layer 300 includes first and second inorganic encapsulation layers 310 and 330 and an organic encapsulation layer 320 interposed between the first and second inorganic encapsulation layers 310 and 330.

The first and second inorganic encapsulation layers 310 and 330 may include at least one inorganic material, such as aluminum oxide, titanium oxide, tantalum oxide, hafnium oxide, zinc oxide, silicon oxide, silicon nitride, and silicon oxynitride. The first inorganic encapsulation insulating layer 310 and the second inorganic encapsulation insulating layer 330 may be a single layer or multi-layer including the aforementioned materials. The organic encapsulation layer 320 may include a polymer-based material. Examples of the polymer-based material may include an acrylic resin, an epoxy-based resin, polyimide, and polyethylene. According to an embodiment, the organic encapsulation layer 320 may include acrylate.

Thicknesses of the first inorganic encapsulation layer 310 and the second inorganic encapsulation layer 330 may be different from each other. The thickness of the first inorganic encapsulation layer 310 may be greater than the thickness of the second inorganic encapsulation layer 330. Alternatively, the thickness of the second inorganic encapsulation layer 330 may be greater than the thickness of the first inorganic encapsulation layer 310, or the thicknesses of the first inorganic encapsulation layer 310 and the second inorganic encapsulation layer 330 may be the same.

An input sensing layer 400 may be disposed on the encapsulation layer 300. The input sensing layer 400 may include touch electrodes TE arranged in the display area DA, and at least one touch insulating layer. In this regard, FIG. 18 illustrates that the input sensing layer 400 includes a first touch insulating layer 410 on the second inorganic encapsulation layer 330, a first conductive line 420 on the first touch insulating layer 410, a second touch insulating layer 430 on the first conductive line 420, a second conductive line 440 on the second touch insulating layer 430, and a third touch insulating layer 450 on the second conductive line 440.

Each of the first touch insulating layer 410, the second touch insulating layer 430, and the third touch insulating layer 450 may include an inorganic insulating material and/or an organic insulating material. According to an embodiment, the first touch insulating layer 410 and the second touch insulating layer 430 may include an inorganic insulating material, such as silicon oxide, silicon nitride, and/or silicon oxynitride, and the third touch insulating layer 450 may include an organic insulating material.

A touch electrode TE of the input sensing layer 400 may have a structure in which the first conductive line 420 and the second conductive line 440 are connected to each other. Alternatively, the touch electrode TE may include one of the first conductive line 420 and the second conductive line 440. In this case, the second touch insulating layer 430 may be omitted.

Each of the first conductive line 420 and the second conductive line 440 may include Al, Cu, and/or Ti, and may be a multi-layer or single layer including the aforementioned materials. For example, each of the first conductive line 420 and the second conductive line 440 may have a three-layered structure of Ti/Al/Ti layers.

Display apparatuses and electronic devices according to embodiments may provide clear images with reduced distortion.

It should be understood that embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (200) comprising:
a substrate (100) comprising a display layer disposed on a first surface of the substrate (100) and having at least a portion that is selectively bent;
a reinforcing member (60) disposed on a second surface of the substrate (100), the second surface being opposite to the first surface; and
a support plate (70) disposed on the reinforcing member,
wherein:
the support plate (70) comprises:
a first pattern region (70-4A) having a plurality of first opening patterns (71A) arranged to correspond to a first portion of the substrate;
a second pattern region (70-4B) connected to the first pattern region (70-4A) and having a plurality of second opening patterns (71B) arranged to correspond to a second portion of the substrate; and
a third pattern region (70-4C) connected to the second pattern region (70-4A) and having a plurality of third opening patterns (71C) arranged to correspond to a third portion of the substrate;
wherein each of the plurality of first opening patterns (71A), each of the plurality of second opening patterns (71B), and each of the plurality of third opening patterns (71C) comprise widths and lengths, the lengths being greater than the widths,
a lengthwise direction of at least one of the plurality of first opening patterns (71A) and a lengthwise direction of at least one of the plurality of second opening patterns (71B) are identical to each other in a first direction, and
a lengthwise direction of at least one of the plurality of third opening patterns (71C) is different from the first direction.

2. The display apparatus (200) of claim 1, wherein lengths of some of the plurality of second opening patterns (71B) sequentially decrease in a second direction away from the first pattern region (70-4A).

3. The display apparatus (200) of claim 2, wherein a length of each of the plurality of second opening patterns (71B) arranged in the second pattern region (70-4B) sequentially decreases by a certain value in the second direction.

4. The display apparatus (200) of any one of the preceding claims, wherein an interval between adjacent second opening patterns (71B) among the plurality of second opening patterns (71B) increases in a second direction away from the first pattern region (70-4A).

5. The display apparatus (200) of claim 4, wherein the interval between the adjacent second opening patterns (71B) in the second direction ranges from 5 µm to 1 mm, and/or wherein the interval between the adjacent second opening patterns (71B) in the second direction sequentially increases by a certain value in a direction away from the first pattern region (70-4A).

6. The display apparatus (200) of any one of the preceding claims, wherein some of the plurality of second opening patterns (71B) have centers which are arranged on a straight line parallel to a width direction of the plurality of second opening patterns (71B) and have respective ends arranged on a diagonal line or a curve.

7. The display apparatus (200) of any one of the preceding claims, wherein:
first opening patterns (71A) adjacent to each other among the plurality of first opening patterns (71A) in the first direction overlap each other at least partially in a second direction different from the first direction; and/or
second opening patterns (71B) adjacent to each other among the plurality of second opening patterns (71B) in the first direction overlap each other at least partially in the second direction.

8. The display apparatus (200) of any one of the preceding claims, wherein an angle formed between the lengthwise direction of each of the plurality of third opening patterns (71C) and the first direction increases in a direction away from the second pattern region (70-4B).

9. The display apparatus (200) of any one of the preceding claims, wherein the lengthwise direction of a third opening pattern (71C) disposed at an outermost edge of the third pattern region (70-4C) among the plurality of third opening patterns (71C) is perpendicular to the first direction.

10. The display apparatus (200) of any one of the preceding claims, wherein an interval between adjacent first opening patterns (71A) arranged in a second direction different from the first direction from among the plurality of first opening patterns (71A) is constant.

11. The display apparatus (200) of any one of the preceding claims, wherein the lengths of the plurality of third opening patterns (71C) are respectively less than the lengths of the plurality of first opening patterns (71A).

12. The display apparatus (200) of any one of the preceding claims, wherein the second pattern region (70-4B) is 5 % to 40 % of a total area obtained by summing respective areas of the first pattern region (70-4A), the second pattern region (70-4B), and the third pattern region (70-4C).

13. The display apparatus (200) of any one of the preceding claims, wherein the third pattern region (70-4C) is more than 0 % to 10 % of a total area obtained by summing respective areas of the first pattern region (70-4A), the second pattern region (70-4B), and the third pattern region (70-4C).

14. An electronic device (1) comprising:
a housing;
a display apparatus (200) that is accommodated in the housing and is foldable or is capable of being withdrawn from a portion of the housing; and
an input module (6) disposed in the housing and which receives a user signal,
wherein the display apparatus (200) is a display apparatus (200) of any one of the preceding claims.

15. The electronic device of claim 14, wherein:
the first pattern region (70-4A) is disposed inside a portion of the housing in which the input module (6) is disposed, and
at least a portion of the first pattern region (70-4A) moves inside the housing when the display apparatus (200) slides.
